# EUROPEAN PATENT APPLICATION

(11) **EP 4 851 717 A1**
(43) Date of publication of application: **09.12.2026**
(21) Application number: 25748711.6
(22) Date of filing: 30.01.2025
(51) Int. Cl.: G03F 7/11, C08F 8/00, C08G 59/16, G03F 7/20

(54) **RESIST UNDERLAYER FILM-FORMING COMPOSITION**

(30) Priority: 31.01.2024 JP 2024012497
(71) Applicant: Nissan Chemical Corporation, Tokyo 103-6119 (JP)
(72) Inventor: MIZUOCHI Ryuta, Toyama-shi, Toyama 939-2792 (JP); TAMURA Mamoru, Toyama-shi, Toyama 939-2792 (JP)
(74) Representative: Hoffmann Eitle
(86) International application number: PCT/JP2025/002939
(87) International publication number: WO 2025/164708

(57) **Abstract**

Provided are a resist underlayer film-forming composition capable of forming a resist underlayer film on which a fine resist pattern can be formed with good sensitivity, and a resist underlayer film, a laminate, a semiconductor element producing method, and a pattern forming method, in all of which the resist underlayer film-forming composition is used.

A resist underlayer film-forming composition contains a solvent and a polymer (A) having, in a side chain, an aromatic hydrocarbon ring and one type or two or more types of polymerizable multiple bonds selected from the group consisting of a carbon-carbon double bond, a carbon-carbon triple bond, a carbon-nitrogen double bond, and a carbon-nitrogen triple bond.

## Description

### Technical Field

The present invention relates to a resist underlayer film-forming composition, a resist underlayer film, a laminate, a semiconductor element producing method, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, the degree of integration of a semiconductor device has been increased, and as an active ray to be used, EUV light (wavelength: 13.5 nm) or an electron beam (EB) has been studied to be put into practical use for the most advanced microfabrication, in addition to an i-line (wavelength: 365 nm), a KrF excimer laser (wavelength: 248 nm), and an ArF excimer laser (wavelength: 193 nm) which have conventionally been used. At the same time, defects in the formation of the resist pattern due to an influence of the semiconductor substrate and the like are a big problem. Therefore, in order to solve this problem, a method of providing a resist underlayer film between a resist and a semiconductor substrate has been widely studied.

Patent Literature 1 discloses an underlayer film-forming composition for lithography containing a naphthalene ring having a halogen atom. Patent Literature 2 discloses a halogenated antireflective film. Patent Literature 3 discloses a resist underlayer film-forming composition.

### Citation List

### Patent Literature

Patent Literature 1: WO 2006/003850 A
Patent Literature 2: JP 2005-526270 A
Patent Literature 3: WO 2020/111068 A

### Summary of Invention

### Technical Problem

For example, a resist underlayer film is desirably characterized in that no intermixing with a resist film formed on an upper layer occurs (the resist film is insoluble in a resist solvent), and a fine resist pattern can be formed.

The present invention has been made in view of the above circumstances, and an object of the present invention is to provide a resist underlayer film-forming composition capable of forming a resist underlayer film on which a fine resist pattern can be formed with good sensitivity, and a resist underlayer film, a laminate, a method for producing a semiconductor element, and a pattern forming method, in all of which the resist underlayer film-forming composition is used.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition, containing a solvent and a polymer (A) having, in a side chain, an aromatic hydrocarbon ring and one type or two or more types of polymerizable multiple bonds selected from the group consisting of a carbon-carbon double bond, a carbon-carbon triple bond, a carbon-nitrogen double bond, and a carbon-nitrogen triple bond.
[2] The resist underlayer film-forming composition according to [1], wherein the polymer (A) has a group represented by formula (A) below: 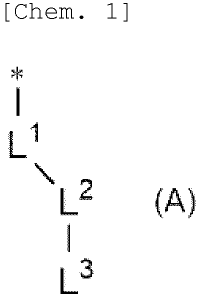 in formula (A), L¹ represents a single bond or a linking group, L² represents a divalent group having the aromatic hydrocarbon ring, L³ represents a monovalent group having the polymerizable multiple bond, and * represents a bond.
[3] The resist underlayer film-forming composition according to [2], wherein in the group represented by formula (A), the L² is represented by formula (b) below: 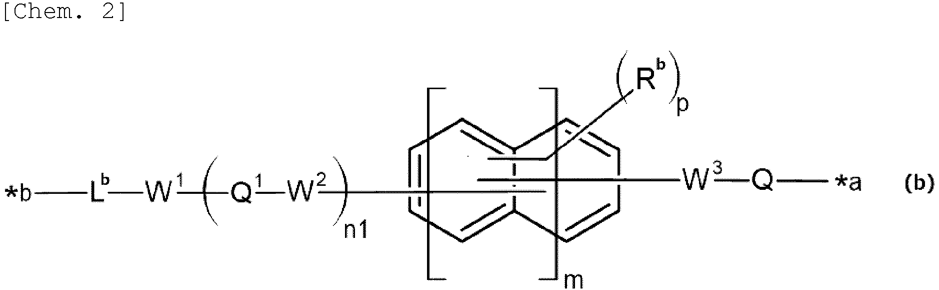 in formula (b),
   W¹, W², and W³ are each independently a single bond, - O-, -C(=O)-O-, -O-C(=O)-, -O-C(=O)-CH₂-, -C(=O)-N(R')-, or -N(R')-C(=O)-, when the number of W²'s is 2 or more, the respective W²'s may be identical to or different from each other, and R' represents a hydrogen atom or an alkyl group having 1 to 6 carbon atoms,
   Q is a single bond, an alkylene group having 1 to 10 carbon atoms, or an alkenylene group having 2 to 10 carbon atoms, and some or all hydrogen atoms in the alkylene group or the alkenylene group may be substituted with a halogen atom,
   L^{b} represents a single bond, an alkylene group having 1 to 12 carbon atoms, or a divalent linking group in which one or more non-adjacent -CH₂- moieties constituting an alkylene group having 1 to 12 carbon atoms are substituted with -O-, -S-, -C(=O)-O-, or O-C(=O)-, and some or all hydrogen atoms in the alkylene group may be substituted with a halogen atom,
   Q¹ is a single bond, a phenylene group, a naphthylene group, or a divalent alicyclic hydrocarbon group having 5 to 8 carbon atoms, and some or all hydrogen atoms in the phenylene group and the naphthylene group may be substituted with a cyano group, a halogen atom, an alkyl group having 1 to 5 carbon atoms, an alkylcarbonyl group having 2 to 6 carbon atoms, or an alkoxy group having 1 to 5 carbon atoms, when the number of Q¹'s is 2 or more, the respective Q¹'s may be identical to or different from each other,
   R^{b} is an alkyl group having 1 to 6 carbon atoms, a haloalkyl group having 1 to 6 carbon atoms, an alkoxy group having 1 to 6 carbon atoms, a haloalkoxy group having 1 to 6 carbon atoms, a cyano group, or a nitro group,
   p is 0, 1, 2, 3, or 4,
   m is 0 or 1,
   n1 is 0, 1, 2, or 3, and
   *a and *b each represent a bond, and *a binds to L¹ and *b binds to L³.
[4] The resist underlayer film-forming composition according to [3], wherein in the divalent group represented by formula (b) of L², a combination of W³ and Q is any of the following combinations: W³ is a single bond and Q is a single bond; W³ is a single bond and Q is an alkylene group having 1 to 10 carbon atoms; and W³ is a single bond and Q is an alkenylene group having 2 to 10 carbon atoms.
[5] The resist underlayer film-forming composition according to [3] or [4], wherein in the divalent group represented by formula (b) of L², a combination of Q¹ and W² is any of the following combinations: Q¹ is a single bond and W² is a single bond; and when n1 is 1, Q¹ is a phenylene group and W² is -C(=O)-O-.
[6] The resist underlayer film-forming composition according to any one of [3] to [5], wherein in the divalent group represented by formula (b) of L², a combination of L^{b} and W¹ is any of the following combinations: L^{b} is a single bond and W¹ is a single bond; L^{b} is an alkylene group having 1 to 10 carbon atoms and W¹ is -O-C(=O)-CH₂-; and L^{b} is an alkylene group having 1 to 10 carbon atoms and W¹ is -O-.
[7] The resist underlayer film-forming composition according to any one of [2] to [6], wherein in the group represented by formula (A), the linking group of L¹ has a structural moiety represented by formula (t1) below or formula (t2) below: 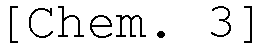 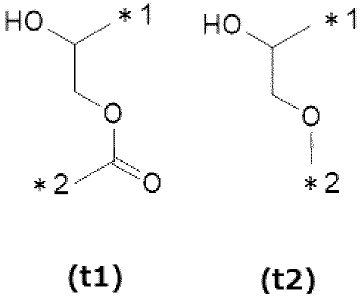 wherein *1 represents a bond on a side opposite to a side bonded to L² in formula (A), and *2 represents a bond bonded to L² in formula (A).
[8] The resist underlayer film-forming composition according to any one of [2] to [7], wherein in the group represented by formula (A), the monovalent group having a polymerizable multiple bond of L³ has a structural moiety represented by formula (u1) below or formula (u2) below: 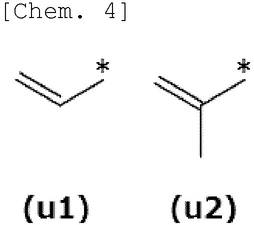 wherein * represents a bond bonded to L² in formula (A) .
[9] The resist underlayer film-forming composition according to [1], wherein the polymer (A) has a structural unit represented by formula (1) below: 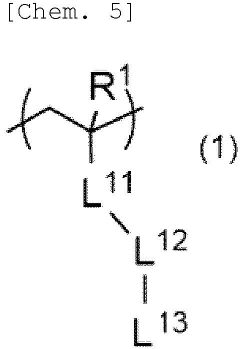 in formula (1), R¹ represents a hydrogen atom or an alkyl group having 1 to 10 carbon atoms, L¹¹ represents a single bond or a linking group, L¹² represents a divalent group having the aromatic hydrocarbon ring, and L¹³ represents a monovalent group having the polymerizable multiple bond.
[10] The resist underlayer film-forming composition according to [9], wherein in the structural unit represented by formula (1), the linking group of L¹¹ is represented by formula (L1-1) below or formula (L1-2) below: 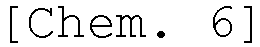 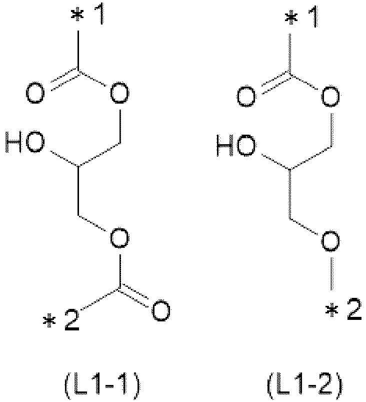 wherein *1 represents a bond bonded to a carbon atom bonded to R¹ in formula (1), and *2 represents a bond bonded to L¹² in formula (1).
[11] The resist underlayer film-forming composition according to [1], wherein the polymer (A) has a structural unit represented by formula (2) below: 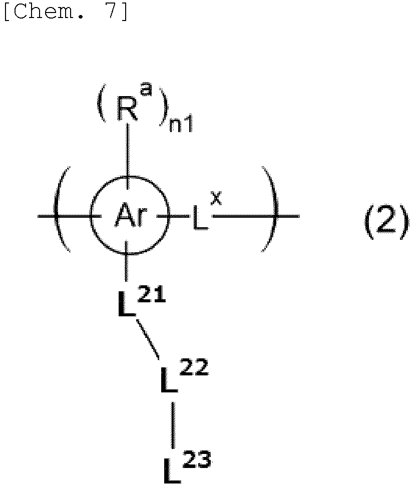 in formula (2), R^{a} represents a hydrogen atom or an alkyl group having 1 to 10 carbon atoms, Ar represents a benzene ring, a naphthalene ring, or an anthracene ring, L^{X} represents a single bond or a divalent group which may have a substituent, L²¹ represents a single bond or a linking group, L²² represents a divalent group having the aromatic hydrocarbon ring, L²³ represents a monovalent group having the polymerizable multiple bond, and n1 is an integer of 0 to 3.
[12] The resist underlayer film-forming composition according to [11], wherein in the structural unit represented by formula (2), the linking group of L²¹ is represented by formula (L1-12) below: 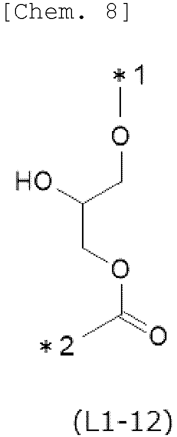 wherein *1 represents a bond bonded to Ar in formula (2), and *2 represents a bond bonded to L²² in formula (1).
[13] The resist underlayer film-forming composition according to [1], wherein the polymer (A) has a structural unit represented by formula (3) below: 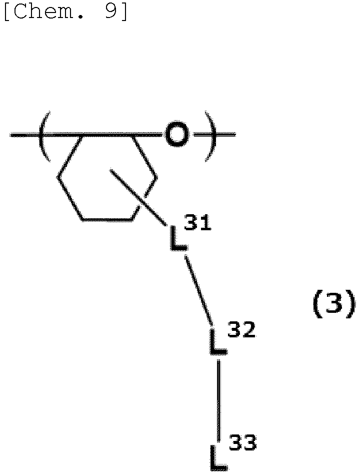 in formula (3), L³¹ represents a single bond or a linking group, L³² represents a divalent group having the aromatic hydrocarbon ring, and L³³ represents a monovalent group having the polymerizable multiple bond.
[14] The resist underlayer film-forming composition according to [13], wherein in the structural unit represented by formula (3), the linking group of L³¹ is represented by formula (L1-13) below: 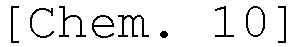 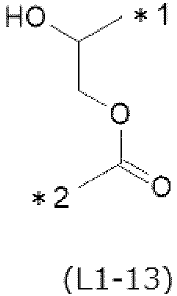 wherein *1 represents a bond bonded to an alicyclic hydrocarbon in formula (3), and *2 represents a bond bonded to L³² in formula (3).
[15] The resist underlayer film-forming composition according to any one of [1] to [15], further containing a crosslinking agent.
[16] A resist underlayer film which is a cured product of the resist underlayer film-forming composition according to any one of [1] to [15].
[17] A laminate, including:
   a semiconductor substrate; and
   the resist underlayer film according to [16].
[18] A semiconductor element producing method, including steps of:
   forming a resist underlayer film on a semiconductor substrate using the resist underlayer film-forming composition according to any one of [1] to [15]; and
   forming a resist film on the resist underlayer film.
[19] A pattern forming method, including steps of:
   forming a resist underlayer film on a semiconductor substrate using the resist underlayer film-forming composition according to any one of [1] to [15];
   forming a resist film on the resist underlayer film;
   irradiating the resist film with light or an electron beam, and then developing the resist film to obtain a resist pattern; and
   etching the resist underlayer film using the resist pattern as a mask.

### Advantageous Effects of Invention

According to the present invention, it is possible to provide a resist underlayer film-forming composition capable of forming a resist underlayer film on which a fine resist pattern can be formed with good sensitivity, and a resist underlayer film, a laminate, a method for producing a semiconductor element, and a pattern forming method, in all of which the resist underlayer film-forming composition is used.

### Brief Description of Drawings

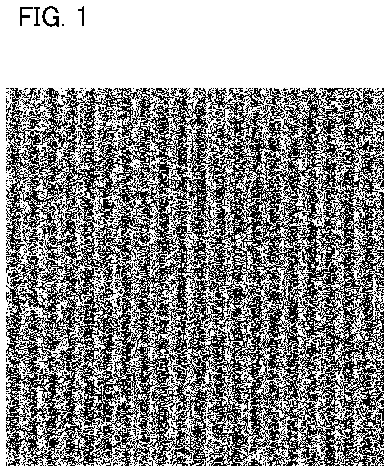

[Fig. 1] Fig. 1 is a view showing an observation photograph of a resist pattern formed in Example 1.

### Description of Embodiments

### (Resist underlayer film-forming composition)

The resist underlayer film-forming composition of the present invention contains a polymer (A) and a solvent.

The resist underlayer film-forming composition may contain a crosslinking agent, a curing catalyst, a thermal radical polymerization initiator, and the like.

A resist pattern having good sensitivity can be formed on a resist underlayer film formed from a resist underlayer film-forming composition containing a polymer (A) and a solvent.

### <Polymer (A)>

The polymer (A) has a polymerizable multiple bond and an aromatic hydrocarbon ring in a side chain. The polymerizable multiple bond and the aromatic hydrocarbon ring are preferably present in the same side chain.

The polymerizable multiple bond is one type or two or more types of polymerizable multiple bonds selected from the group consisting of a carbon-carbon double bond, a carbon-carbon triple bond, a carbon-nitrogen double bond, and a carbon-nitrogen triple bond.

The polymer (A) is an organic polymer.

The polymer (A) may be a homopolymer or a copolymer.

The polymer (A) has, for example, a (meth)acryloyl group, a vinylaryl group (e.g. a styryl group), a vinyloxy group, or an allyl group as a group having a polymerizable multiple bond in a side chain.

The polymer (A) preferably has a group represented by formula (A) below.

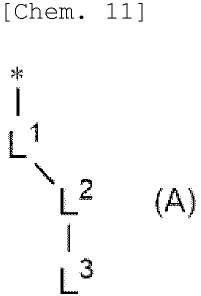

In formula (A), L¹ represents a single bond or a linking group, L² represents a divalent group having the aromatic hydrocarbon ring, L³ represents a monovalent group having the polymerizable multiple bond, and * represents a bond.

In the group represented by formula (A), L² is preferably represented by formula (b) below. 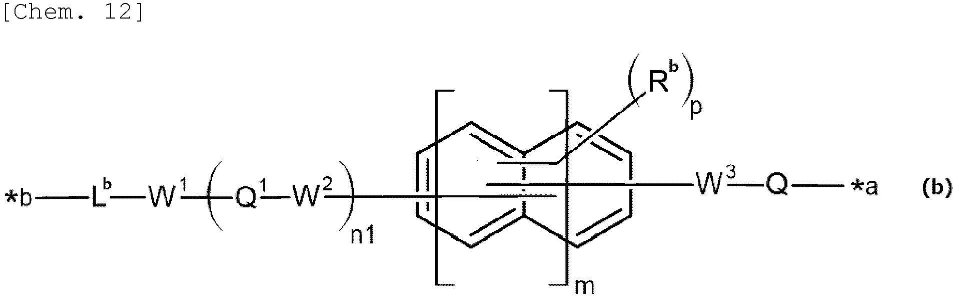 In formula (b),
W¹, W², and W³ are each independently a single bond, - O-, -C(=O)-O-, -O-C(=O)-, -O-C(=O)-CH₂-, -C(=O)-N(R')-, or -N(R')-C(=O)-, when the number of W²'s is 2 or more, the respective W²'s may be identical to or different from each other, and R' represents a hydrogen atom or an alkyl group having 1 to 6 carbon atoms,
Q is a single bond, an alkylene group having 1 to 10 carbon atoms, or an alkenylene group having 2 to 10 carbon atoms, and some or all hydrogen atoms in the alkylene group or the alkenylene group may be substituted with a halogen atom,
L^{b} represents a single bond, an alkylene group having 1 to 12 carbon atoms, or a divalent linking group in which one or more non-adjacent -CH₂- moieties constituting an alkylene group having 1 to 12 carbon atoms are substituted with -O-, -S-, -C(=O)-O-, or O-C(=O)-, and some or all hydrogen atoms in the alkylene group may be substituted with a halogen atom,
Q¹ is a single bond, a phenylene group, a naphthylene group, or a divalent alicyclic hydrocarbon group having 5 to 8 carbon atoms, and some or all hydrogen atoms in the phenylene group and the naphthylene group may be substituted with a cyano group, a halogen atom, an alkyl group having 1 to 5 carbon atoms, an alkylcarbonyl group having 2 to 6 carbon atoms, or an alkoxy group having 1 to 5 carbon atoms, when the number of Q¹'s is 2 or more, the respective Q¹'s may be identical to or different from each other,
R^{b} is an alkyl group having 1 to 6 carbon atoms, a haloalkyl group having 1 to 6 carbon atoms, an alkoxy group having 1 to 6 carbon atoms, a haloalkoxy group having 1 to 6 carbon atoms, a cyano group, or a nitro group,
p is 0, 1, 2, 3, or 4,
m is 0 or 1,
n1 is 0, 1, 2, or 3, and
*a and *b each represent a bond, and *a binds to L¹ and *b binds to L³.

Examples of the alkyl group having 1 to 10 carbon atoms include a methyl group, an ethyl group, a n-propyl group, an i-propyl group, a cyclopropyl group, a n-butyl group, an i-butyl group, a s-butyl group, a t-butyl group, a cyclobutyl group, a 1-methyl-cyclopropyl group, a 2-methyl-cyclopropyl group, a n-pentyl group, a 1-methyl-n-butyl group, a 2-methyl-n-butyl group, a 3-methyl-n-butyl group, a 1,1-dimethyl-n-propyl group, 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, a n-heptyl group, a cycloheptyl group, a norbornyl group, a n-octyl group, a cyclooctyl group, a n-nonyl group, an isobornyl group, a tricyclononyl group, a n-decyl group, an adamantyl group, and a tricyclodecyl group. Among these groups, a methyl group is preferable.

The alkenylene group can be linear or branched and contain at least one double bond in the chain, and examples of the alkenylene group having 2 to 10 carbon atoms include a vinylene group, a 1-propenylene group, a 2-propenylene group, a 1-butenylene group, a 2-butenylene group, a 1-pentenylene group, a 2-pentenylene group, a 1-hexenylene group, and a 2-hexenylene group.

When L¹ in formula (A) is a linking group, the number of carbon atoms of the linking group is not particularly limited, and is, for example, 1 to 10.

When L¹ is a linking group, examples of the linking group include a linking group having a structure obtained by reacting an epoxy group with a nucleophilic functional group.

Examples of the nucleophilic functional group include one type or two or more types selected from the group consisting of a carboxy group, a hydroxy group, an amino group, and a thiol group. The hydroxy group may be a phenolic hydroxy group, or need not be a phenolic hydroxy group.

The linking group of L¹ preferably has a structural moiety represented by formula (t1) below or formula (t2) below.

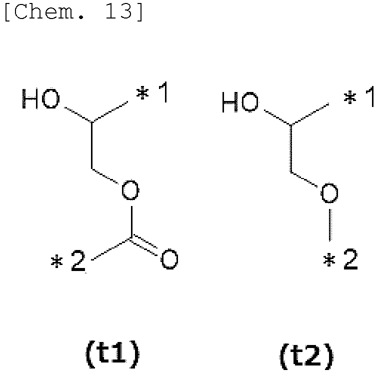

In the formulae, *1 represents a bond on a side opposite to a side bonded to L² in formula (A), and *2 represents a bond bonded to L² in formula (A).

Examples of L¹ include the following linking groups (L1-1) to (L1-11).

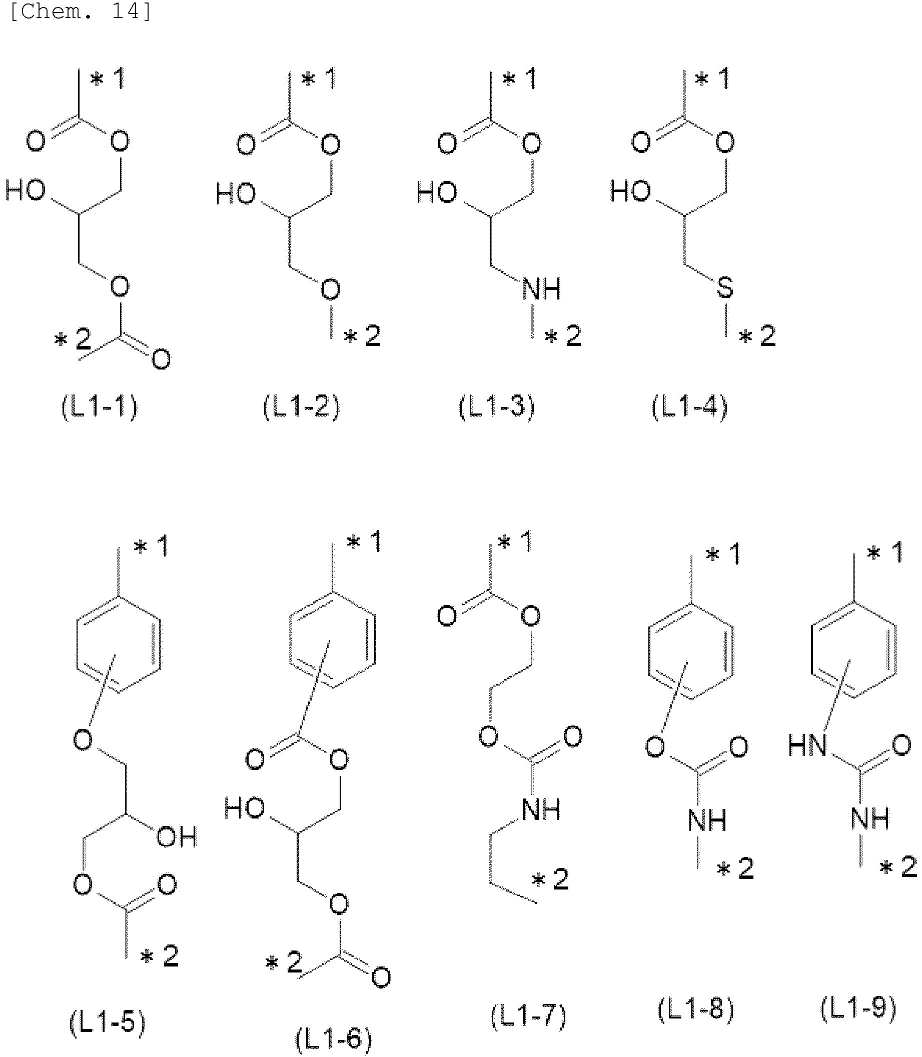

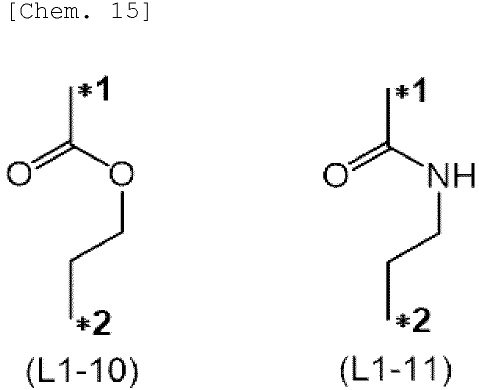

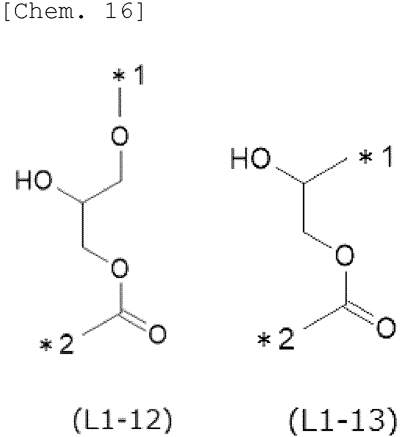

In the formulae, *1 represents a bond on a side opposite to a side bonded to L² in formula (A), and *2 represents a bond bonded to L² in formula (A).

L² is a divalent group having an aromatic hydrocarbon ring, and is preferably, for example, a divalent group represented by formula (b).

Preferred embodiments of the divalent group represented by formula (b) include the following cases.

It is preferable that in the divalent group represented by formula (b), the combination of W³ and Q is any of the following combinations: W³ is a single bond and Q is a single bond; W³ is a single bond and Q is an alkylene group having 1 to 10 carbon atoms; and W³ is a single bond and Q is an alkenylene group having 2 to 10 carbon atoms.

It is preferable that in the divalent group represented by formula (b), the combination of Q¹ and W² is any of the following combinations: Q¹ is a single bond and W² is a single bond; and when n1 is 1, Q¹ is a phenylene group and W² is -C(=O)-O-.

It is preferable that in the divalent group represented by formula (b), the combination of L^{b} and W¹ is any of the following combinations: L^{b} is a single bond and W¹ is a single bond; L^{b} is an alkylene group having 1 to 10 carbon atoms and W¹ is -O-C(=O)-CH₂-; and L^{b} is an alkylene group having 1 to 10 carbon atoms and W¹ is -O-.

Examples of L² include the following divalent groups (L2-1) to (L2-5).

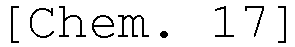

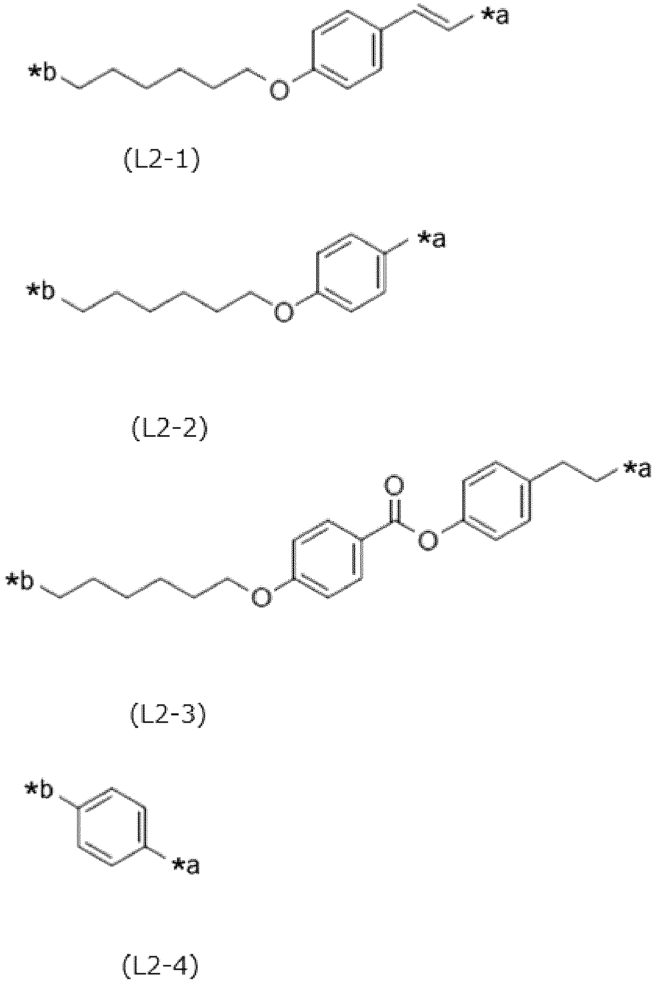

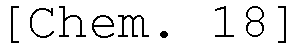

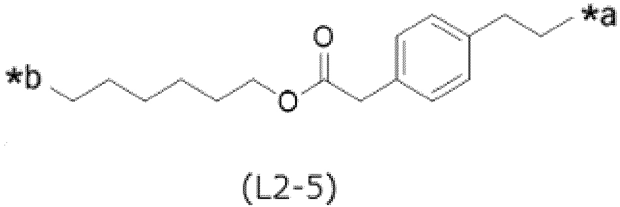

In the formulae, *a represents a bond bonded to L¹ in formula (A), and *b represents a bond bonded to L³ in formula (A).

L³ is a monovalent group having a polymerizable multiple bond. The monovalent group may be a polymerizable multiple bond itself.

The number of carbon atoms of the monovalent group is not particularly limited, and may be, for example, 1 to 20 or 1 to 10.

The monovalent group having a polymerizable multiple bond of L³ preferably has a structural moiety represented by formula (u1) below or formula (u2) below.

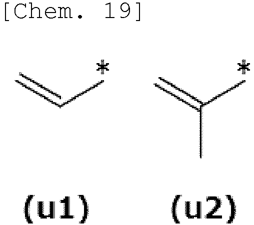

In the formulae, * represents a bond bonded to L² in formula (A).

Examples of L³ include the following monovalent groups (L3-1) to (L3-81).

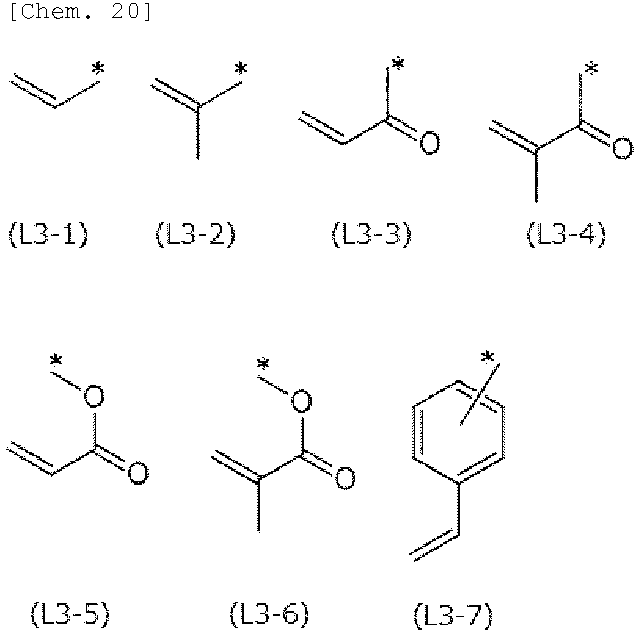

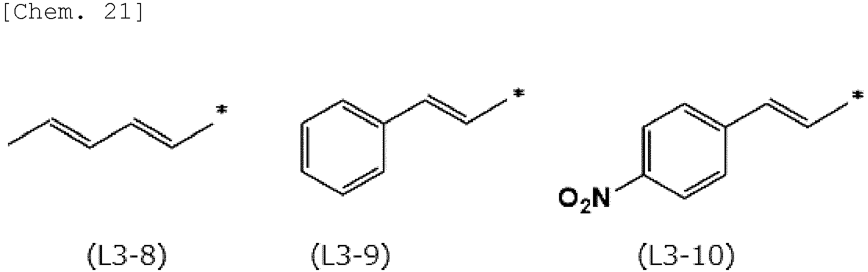

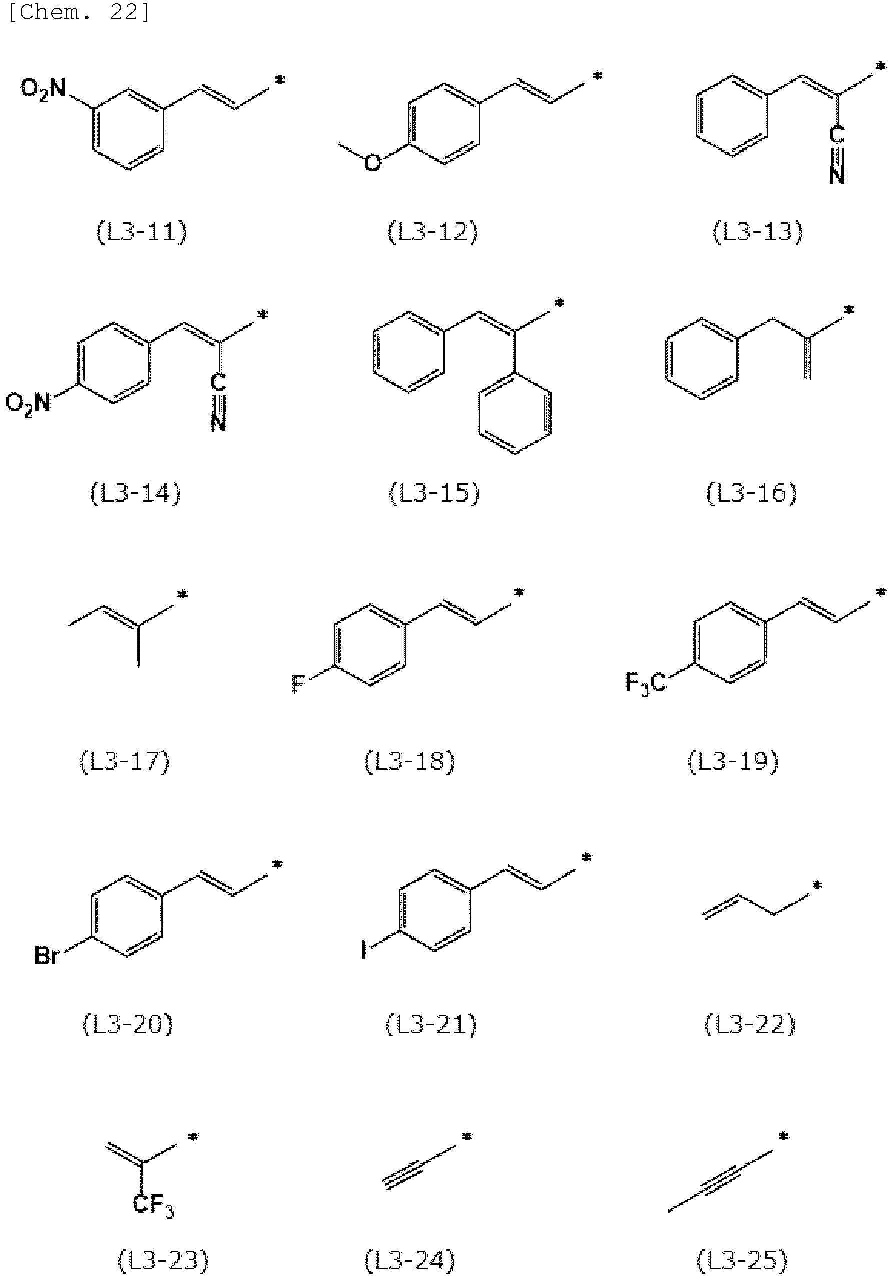

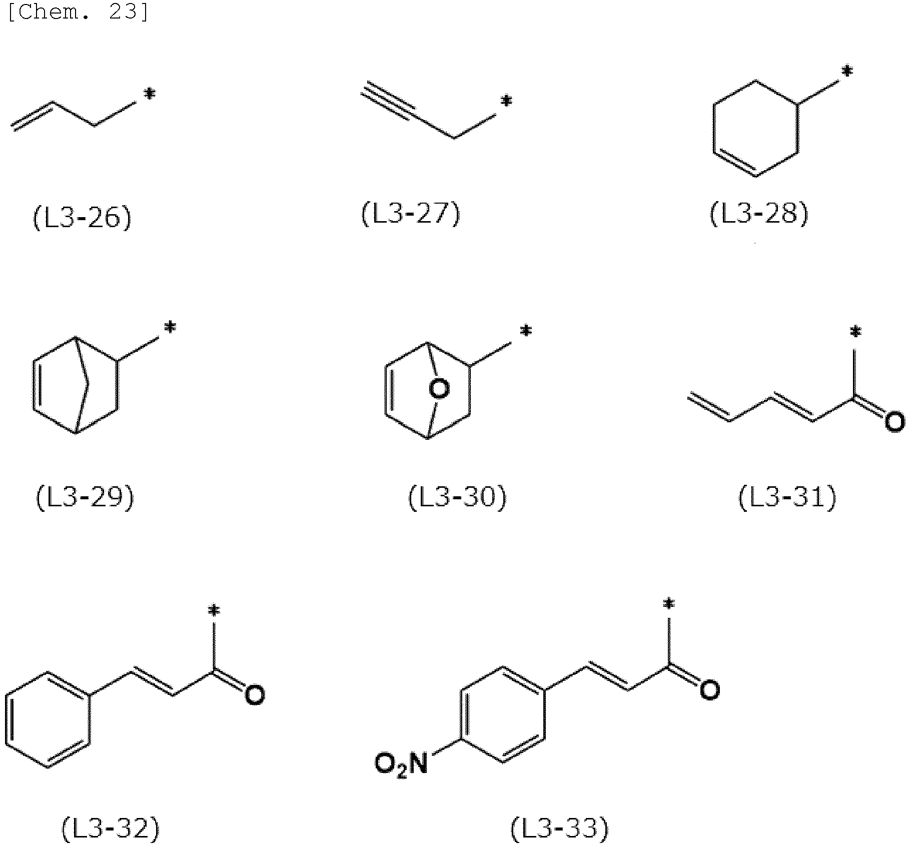

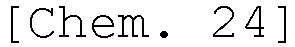

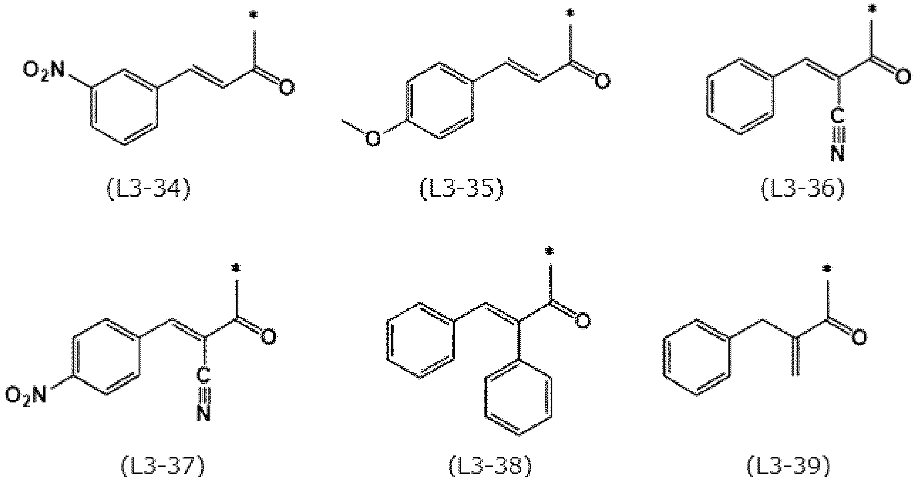

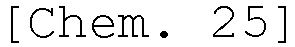

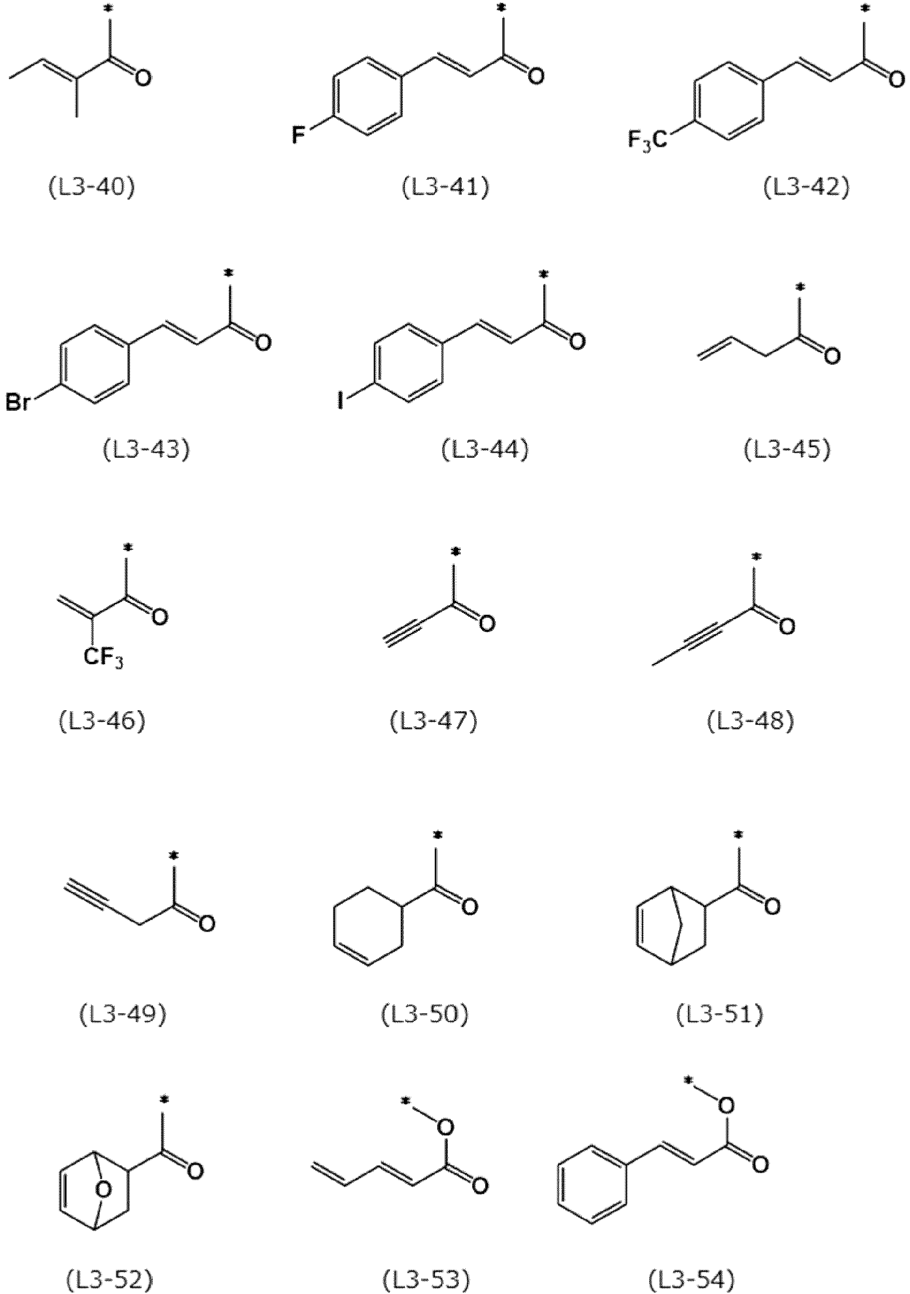

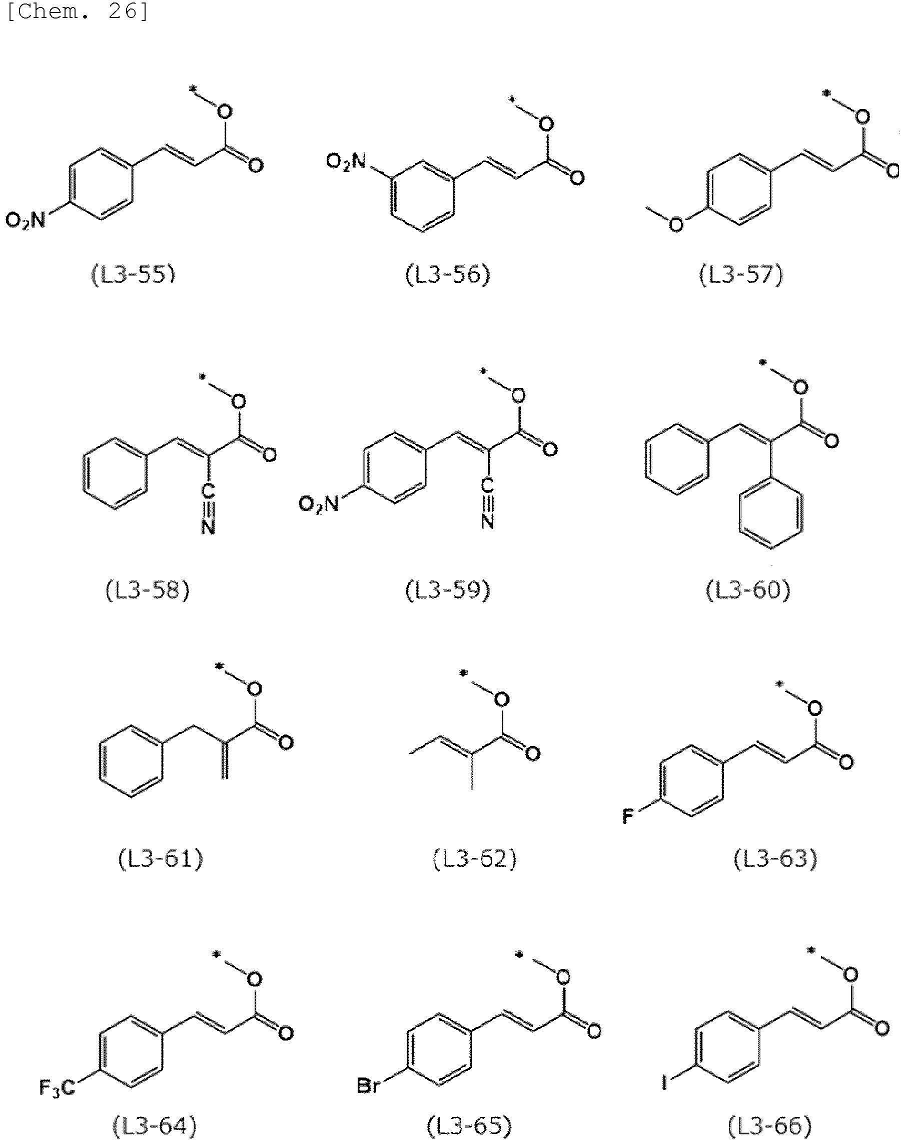

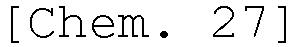

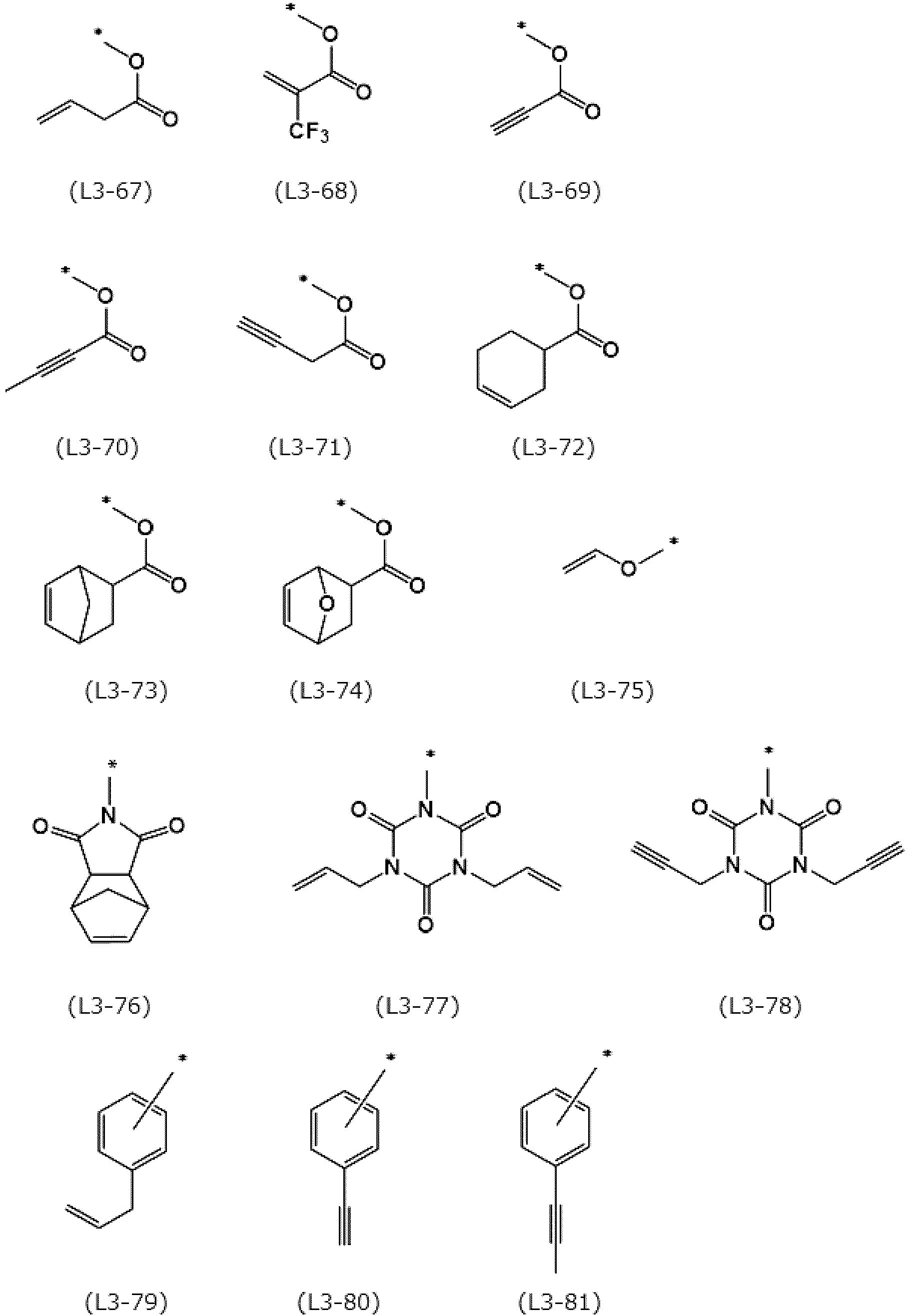

In the formulae, * represents a bond.

The polymer (A) having a group represented by formula (A) can be obtained, for example, by reacting a resin containing an epoxy group with a resin containing a nucleophilic functional group.

Examples of the nucleophilic functional group include one type or two or more types selected from the group consisting of a carboxy group, a hydroxy group, an amino group, and a thiol group. The hydroxy group may be a phenolic hydroxy group, or need not be a phenolic hydroxy group.

For example, when an epoxy group reacts with a carboxy group, the following reaction occurs to form the following structure (S1).

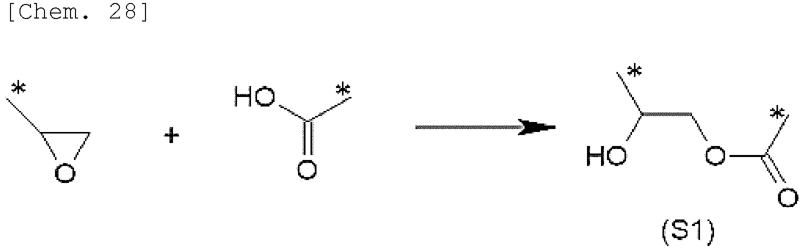

In the formula, * represents a bond.

Preferred embodiments of the polymer (A) according to the present invention may include, for example, the polymers described in the following first to third embodiments.

### <<First Embodiment>>

Examples of the polymer (A) of a first embodiment include a polymer having a structural unit represented by formula (1) below.

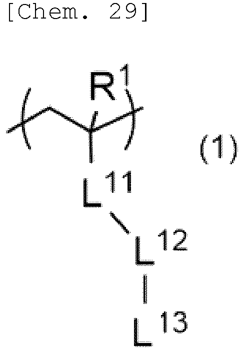

In formula (1), R¹ represents a hydrogen atom or an alkyl group having 1 to 10 carbon atoms, L¹¹ represents a single bond or a linking group, L¹² represents a divalent group having the aromatic hydrocarbon ring, and L¹³ represents a monovalent group having the polymerizable multiple bond.
L¹¹ represents one similar to L¹ in formula (A).
L¹² represents one similar to L² in formula (A).
L¹³ represents one similar to L³ in formula (A).

In the present invention, in formula (1), a linking group of L¹¹ is preferably a group represented by formula (L1-1) below or formula (L1-2) below.

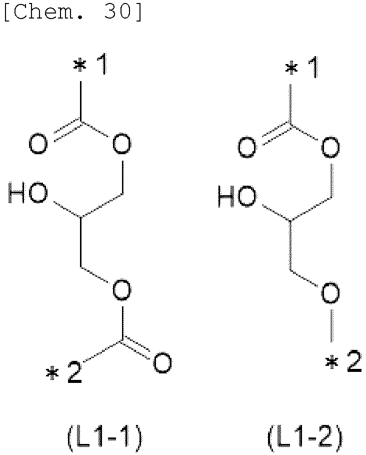

In the formulae, *1 represents a bond bonded to a carbon atom bonded to R¹ in formula (1), and *2 represents a bond bonded to L¹² in formula (1).

The polymer (A) of the first embodiment can be obtained, for example, by reacting a glycidyl (meth)acrylate-based polymer (E1) with a compound (C1) having a polymerizable multiple bond, an aromatic hydrocarbon ring, and a carboxy group, as described below. The glycidyl (meth)acrylate-based polymer may be a homopolymer or a copolymer. Examples of the copolymer include a copolymer of glycidyl (meth)acrylate and 2-hydroxyethyl (meth)acrylate and a copolymer of glycidyl (meth)acrylate and 2-hydroxypropyl (meth)acrylate.

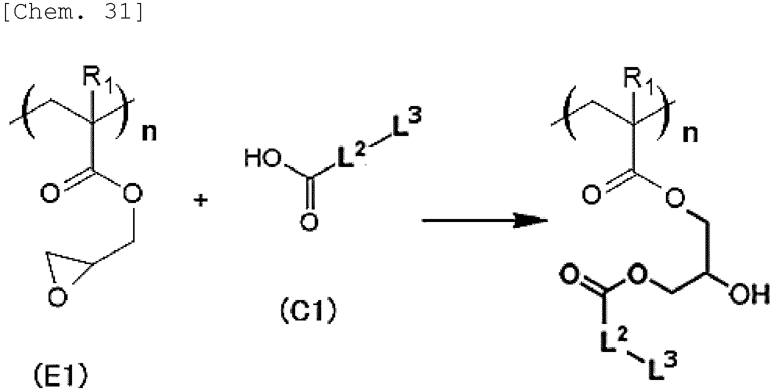

In the formulae, R¹ has the same meaning as R¹ in formula (1). L² has the same meaning as L¹² in formula (1). L³ has the same meaning as L¹³ in formula (1).

The reaction can be performed, for example, in the presence of a catalyst such as tetrabutylphosphonium bromide.

### <<Second Embodiment>>

Examples of the polymer (A) of a second embodiment include a polymer having a structural unit represented by formula (2) below.

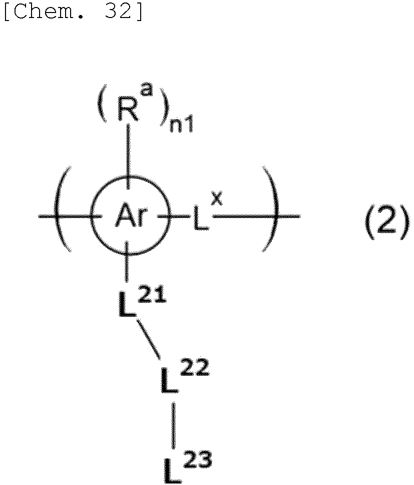

In formula (2), R^{a} represents a hydrogen atom or an alkyl group having 1 to 10 carbon atoms, Ar represents a benzene ring, a naphthalene ring, or an anthracene ring, L^{X} represents a single bond or a divalent group which may have a substituent, L²¹ represents a single bond or a linking group, L²² represents a divalent group having the aromatic hydrocarbon ring, L²³ represents a monovalent group having the polymerizable multiple bond, and n1 is an integer of 0 to 3.
L²¹ represents one similar to L¹ in formula (A).
L²² represents one similar to L² in formula (A).
L²³ represents one similar to L³ in formula (A).

In the present invention, in formula (2), a linking group of L²¹ is preferably a group represented by formula (L1-12) below.

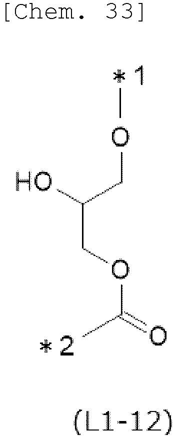

In the formula, *1 represents a bond bonded to Ar in formula (2), and *2 represents a bond bonded to L²² in formula (1).

The divalent group of L^{X} represents, for example, an alkylene group having 1 to 10 carbon atoms, an aromatic hydrocarbon group having 6 to 25 carbon atoms, or a group in which two or more of these groups are combined.

The alkylene group of L^{X} may be any of linear, branched, and cyclic alkylene groups.

Examples of the aromatic hydrocarbon group of L^{X} include monocyclic or fused-ring aromatic hydrocarbon groups, and it may be a linked ring in which these aromatic hydrocarbon groups are linked to each other.

Examples of the substituent that may substitute the divalent group of L^{X} include a group containing a (meth)acryloyloxy group and an alkoxy group.

The polymer (A) of the second embodiment can be obtained, for example, by reacting a polymer having a structural unit represented by formula (2-1') below with a compound having a polymerizable multiple bond, an aromatic hydrocarbon ring, and a carboxy group.

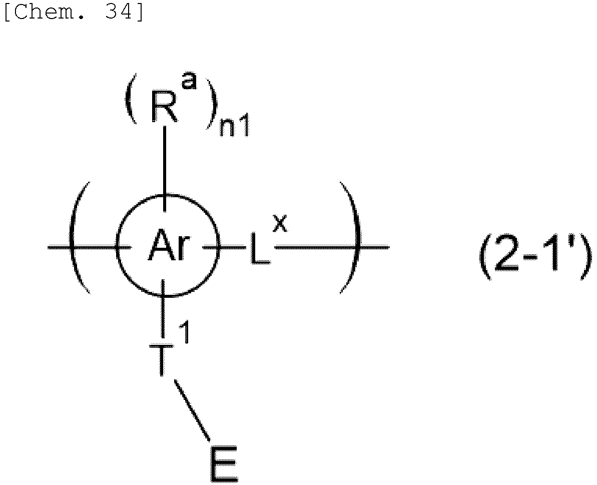

In formula (2-1'), Ar, R^{a}, n1, and L^{X} have the same meanings as Ar, R^{a}, n1, and L^{X} in formula (2), respectively, T¹ represents a single bond or an alkylene group having 1 to 10 carbon atoms which may be interrupted by an ether bond, an ester bond, or an amide bond, and E is a group having an epoxy group.

The polymer (A) of the second embodiment can be obtained, for example, by reacting a polymer (E2) having an epoxy group below with a compound (C1) having a polymerizable multiple bond, an aromatic hydrocarbon ring, and a carboxy group.

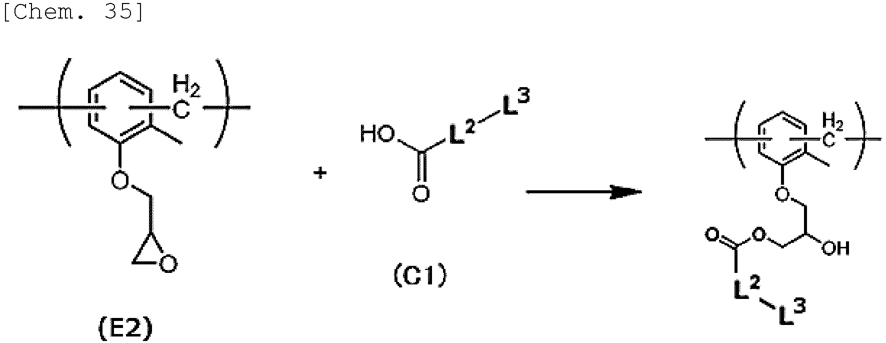

In the formulae, L² has the same meaning as L²² in formula (2), and L³ has the same meaning as L²³ in formula (2) .

Examples of the polymer having a structural unit represented by formula (2-1') include polymers having a structural unit below.

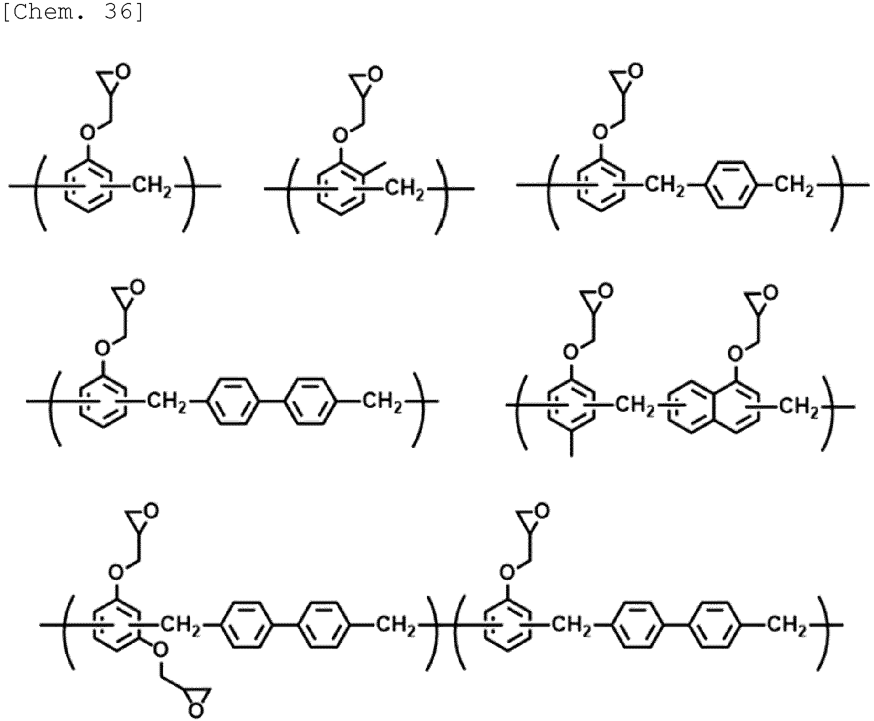

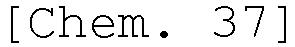

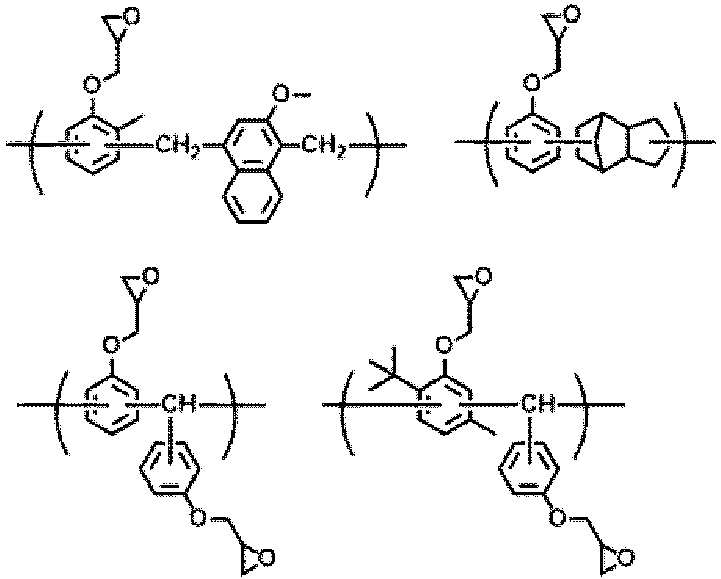

### <<Third Embodiment>>

Examples of the polymer (A) of a third embodiment include a polymer having a structural unit represented by formula (3) below.

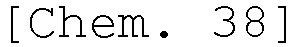

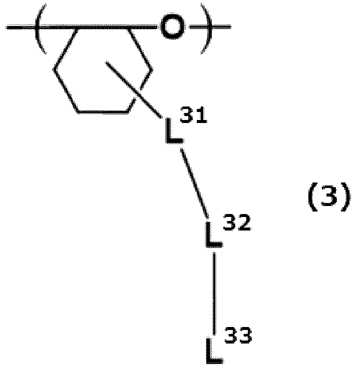

In formula (3), L³¹ represents a single bond or a linking group, L³² represents a divalent group having the aromatic hydrocarbon ring, and L³³ represents a monovalent group having the polymerizable multiple bond.
L³¹ represents one similar to L¹ in formula (A).
L³² represents one similar to L² in formula (A).
L³³ represents one similar to L³ in formula (A).

In the present invention, in formula (3), a linking group of L³¹ is preferably a group represented by formula (L1-13) below.

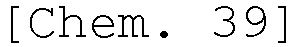

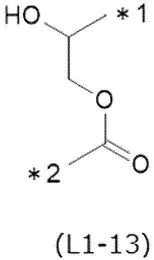

In the formula, *1 represents a bond bonded to an alicyclic hydrocarbon in formula (3), and *2 represents a bond bonded to L³² in formula (3).

The polymer (A) of the third embodiment can be obtained, for example, by reacting a polymer having a structural unit represented by formula (3-1') below with a compound having a polymerizable multiple bond, an aromatic hydrocarbon ring, and a carboxy group.

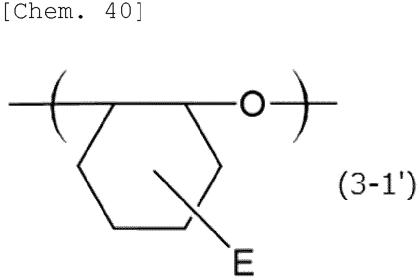

In formula (3-1'), E is a group having an epoxy group.

The polymer (A) of the third embodiment can be obtained, for example, by reacting a polymer (E3) having an epoxy group below with a compound (C1) having a polymerizable multiple bond, an aromatic hydrocarbon ring, and a carboxy group.

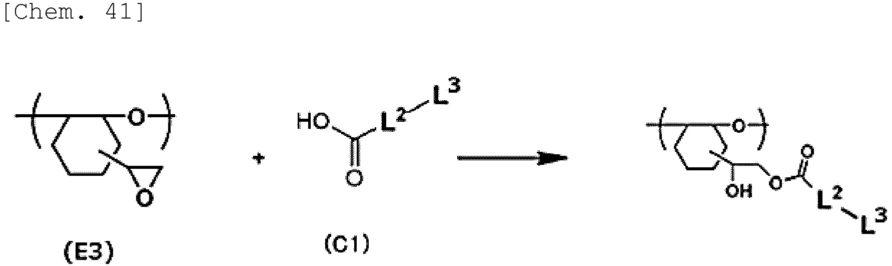

In the formulae, L² has the same meaning as L³² in formula (3), and L³ has the same meaning as L³³ in formula (3).

Examples of the polymer having a structural unit represented by formula (3-1') include a polymer having a structural unit below.

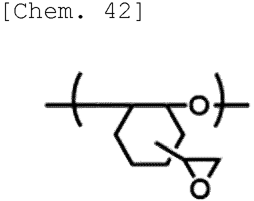

Examples of preferred embodiments of the polymer (A) include polymers having a structural unit below.

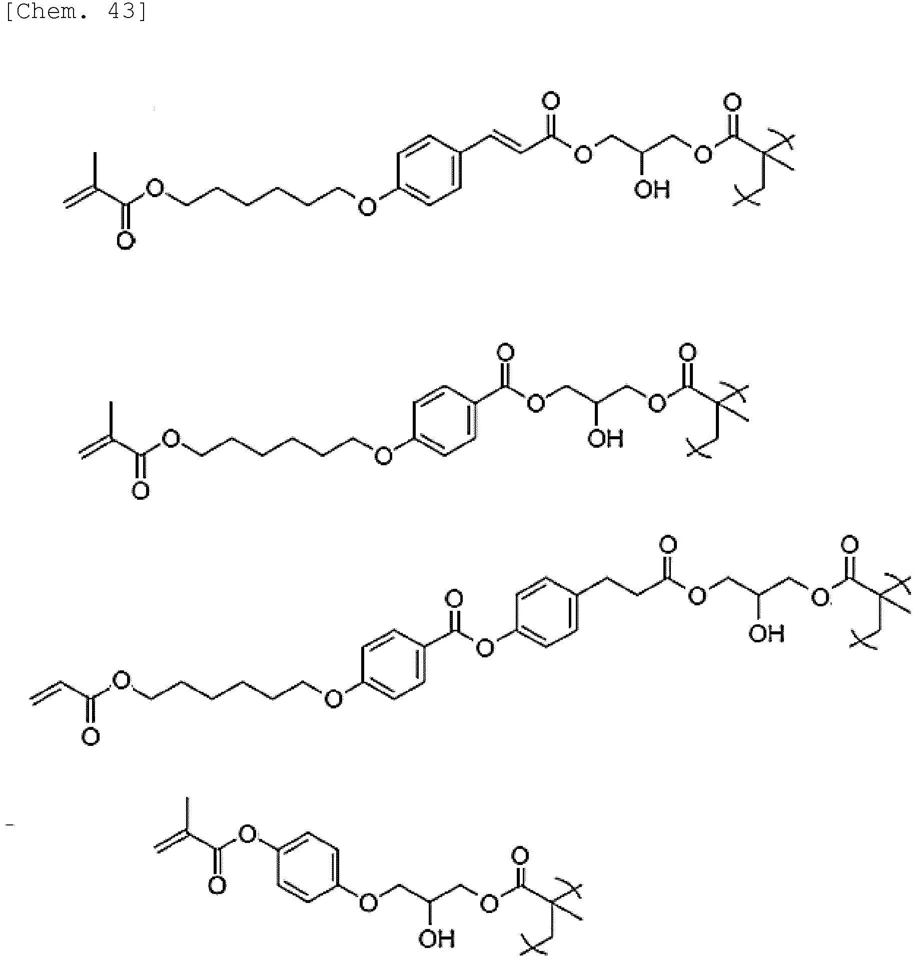

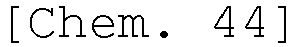

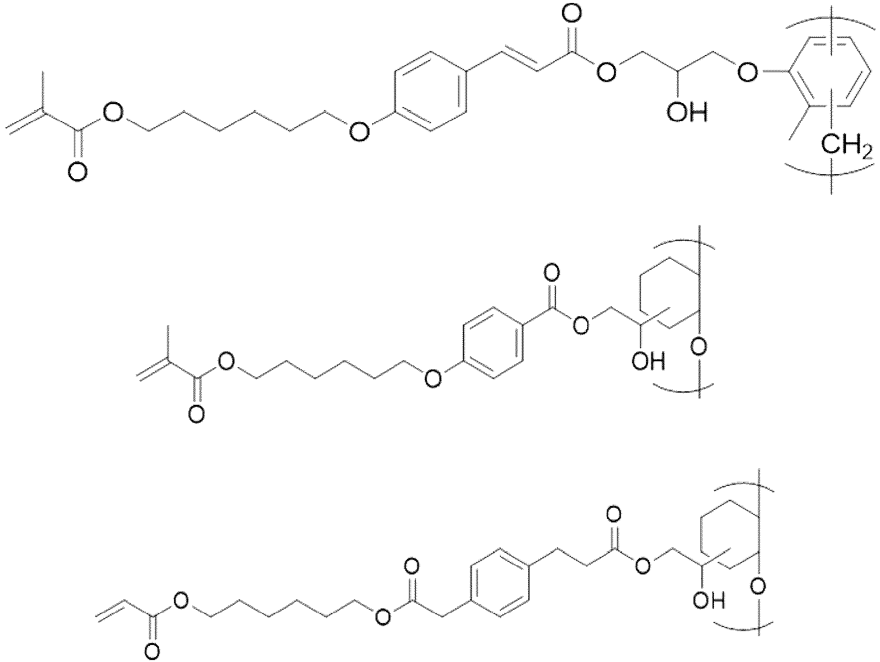

The polymer (A) may have a structural unit other than the structural unit represented by formula (1). Examples of such a structural unit include a structural unit represented by formula (4) below, a structural unit represented by formula (5) below, and a structural unit represented by formula (6) below.

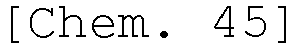

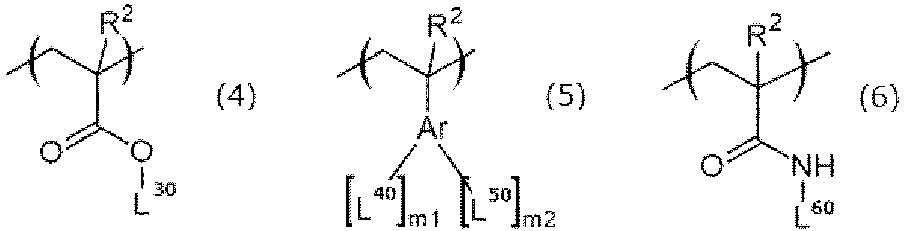

In formula (4), R² represents a hydrogen atom or an alkyl group having 1 to 10 carbon atoms, and L³⁰ represents a monovalent group having 1 to 20 carbon atoms.

In formula (5), R² represents a hydrogen atom or an alkyl group having 1 to 10 carbon atoms, Ar represents a benzene ring or a naphthalene ring, and L⁴⁰ represents a hydroxy group, a cyano group, a nitro group, or an amino group (-NH₂), L⁵⁰ represents a halogen atom, an alkyl group having 1 to 6 carbon atoms, or an alkoxy group having 1 to 6 carbon atoms, m1 represents an integer of 0 to 3, m2 represents an integer of 0 to 5, provided that the sum of m1 and m2 is 0 to 5, when m1 is 2 or 3, a plurality of L⁴⁰'s may be identical or different, and when m2 is 2 to 5, a plurality of L⁵⁰s may be identical or different.

In formula (6), R² represents a hydrogen atom or an alkyl group having 1 to 10 carbon atoms, L⁶⁰ represents a monovalent organic group selected from an alkyl group having 1 to 10 carbon atoms and an aryl group having 6 to 40 carbon atoms, and at least one hydrogen atom of the alkyl group and the aryl group is optionally substituted with a hydroxy group or an alkoxy group having 1 to 6 carbon atoms.

The monovalent group having 1 to 20 carbon atoms in L³⁰ in formula (4) represents, for example, a monovalent organic group selected from an alkyl group having 1 to 10 carbon atoms and an aryl group having 6 to 40 carbon atoms, and at least one hydrogen atom of the alkyl group and the aryl group is optionally substituted with a hydroxy group. In the alkyl group, an oxygen atom may be inserted between a carbon atom and a carbon atom.

Examples of the monovalent group having 1 to 20 carbon atoms in L³⁰ include a group represented by formula (4-1) below.

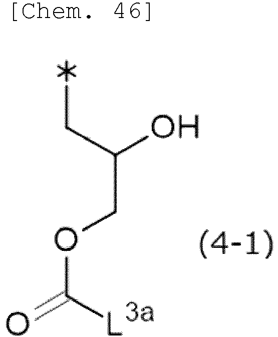

In formula (4-1), L^{3a} represents an optionally substituted alkyl group having 1 to 6 carbon atoms or an optionally substituted aromatic hydrocarbon group.

Examples of the aromatic hydrocarbon group in L^{3a} include a phenyl group and a naphthyl group.

Examples of the substituent in the optionally substituted alkyl group having 1 to 6 carbon atoms in L^{3a} include a halogen atom and a hydroxy group. The number of substituents may be 1 or more. When a plurality of substituents are present, the plurality of substituents may be identical or different.

Examples of the substituent in the optionally substituted aromatic hydrocarbon group in L^{3a} include a halogen atom, a hydroxy group, and an alkyl group having 1 to 3 carbon atoms optionally substituted with a halogen atom. The number of substituents may be 1 or more. When a plurality of substituents are present, the plurality of substituents may be identical or different.

Specific examples of the alkyl group having 1 to 10 carbon atoms represented by R² and the alkyl group having 1 to 10 carbon atoms represented by L³⁰ and L⁶⁰ are as described above.

Examples of the halogen atom in L⁵⁰ include a fluorine atom, a chlorine atom, a bromine atom, and an iodine atom.

Examples of the alkyl group having 1 to 6 carbon atoms in L⁵⁰ include a methyl group, an ethyl group, a n-propyl group, an i-propyl group, a cyclopropyl group, a n-butyl group, and an i-butyl group.

Examples of the alkoxy group having 1 to 6 carbon atoms in L⁵⁰ include a methoxy group, an ethoxy group, a propoxy group, and a butoxy group.

m1 represents an integer of 0 to 3, and may be 0, 1, 2, or 3.

m2 represents an integer of 0 to 5, and may be 0, 1, 2, 3, 4, or 5.

Examples of the aryl group having 6 to 40 carbon atoms represented by L³⁰ and L⁶⁰ include a phenyl group, an o-methylphenyl group, an m-methylphenyl group, a p-methylphenyl group, an o-chlorophenyl group, a m-chlorophenyl group, a p-chlorophenyl group, an o-fluorophenyl group, a p-fluorophenyl group, an o-methoxyphenyl group, a p-methoxyphenyl group, a p-nitrophenyl group, a p-cyanophenyl group, an α-naphthyl group, a β-naphthyl group, an o-biphenylyl group, a m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Examples of the alkoxy group having 1 to 6 carbon atoms in L⁶⁰ include a methoxy group, an ethoxy group, a propoxy group, and a butoxy group.

The ratio of the structural unit represented by at least any one of formula (1) to formula (3) in the polymer (A) is not particularly limited, and the molar ratio of the structural unit represented by any one of formula (1) to formula (3) may be, for example, 20 mol% to 100 mol%, or 20 mol% or more and less than 100 mol%, with respect to all the structural units of the polymer (A).

The ratio of the structural unit represented by formula (4) in the polymer (A) is not particularly limited, and the molar ratio of the structural unit represented by formula (4) may be, for example, 0 mol% to 80 mol%, or more than 0 mol% and 80 mol% or less, with respect to all the structural units of the polymer (A).

The polymer (A) may contain another structural unit other than the structural unit represented by any one of formula (1) to formula (3) and the structural unit represented by formula (4). In that case, the molar ratio of the another structural unit to all the structural units of the polymer (A) is, for example, more than 0 mol% and 20 mol% or less.

The polymer (A) is not, for example, a polysiloxane.

The polymer (A) is not, for example, a hydrolysis condensate of a hydrolyzable silane.

The polymer (A) is not, for example, a reaction product of a tetracarboxylic dianhydride and a diepoxy compound having two epoxy groups.

The polymer (A) is not, for example, a reaction product of a tetracarboxylic dianhydride, a diepoxy compound having two epoxy groups, and a monohydroxy compound having one hydroxy group.

The polymer (A) does not have, for example, an isocyanuric acid skeleton having an alkenyl group. Examples of the alkenyl group include an alkenyl group having 3 to 6 carbon atoms. Examples of the alkenyl group having 3 to 6 carbon atoms include an allyl group.

The molecular weight of the polymer (A) is not particularly limited.

The lower limit of the weight-average molecular weight of the polymer (A) is, for example, 500, 1,000, 2,000, or 3,000.

The upper limit of the weight-average molecular weight of the polymer (A) is, for example, 100,000, 50,000, 30,000, 20,000, or 10,000.

### <Solvent>

The solvent is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of the alkylene glycol monoalkyl ether include an alkylene group having 2 to 4 carbon atoms.

Examples of the alkyl group of the monocarboxylic acid ester of the alkylene glycol monoalkyl ether include an alkyl group having 1 to 4 carbon atoms.

Examples of the monocarboxylic acid of the monocarboxylic acid ester of the alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents, alkylene glycol monoalkyl ether, or a monocarboxylic acid ester of alkylene glycol monoalkyl ether is preferable.

One type of these solvents can be used alone or two or more types thereof can be used in combination.

The mass ratio of the organic solvent in the solvent is not particularly limited, but is preferably 50 mass% to 100 mass%.

The content of the solvent in the resist underlayer film-forming composition is not particularly limited, and is preferably 50 mass% to 99.99 mass%, more preferably 75 mass% to 99.95 mass%, and particularly preferably 90 mass% to 99.9 mass%.

### <Crosslinking agent>

The crosslinking agent is not particularly limited.

The crosslinking agent has a structure different from that of the polymer (A).

As the crosslinking agent, an aminoplast crosslinking agent and a phenoplast crosslinking agent are preferable.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent include a compound having two or more structures shown below.

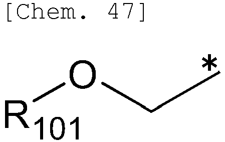

In the structure, R₁₀₁ represents a hydrogen atom, an alkyl group having 1 to 4 carbon atoms, or an alkoxyalkyl group having 2 to 6 carbon atoms, and * represents a bond.

The bond is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferable.

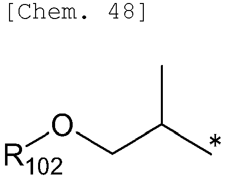

In the structure, R₁₀₂ represents a hydrogen atom, a methyl group, or an ethyl group, and * represents a bond.

As the crosslinking agent, a melamine compound, a guanamine compound, a glycoluril compound, a urea compound, or a compound having a phenolic hydroxy group is preferable. One type of these can be used alone or two or more types thereof can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by formula (1E) below.

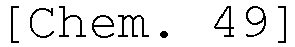

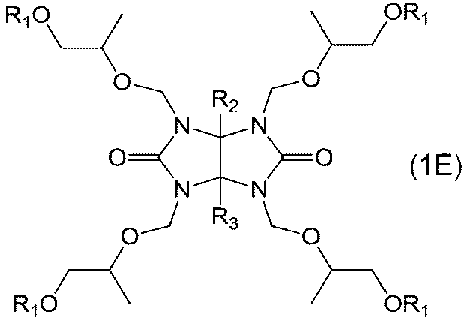

In formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by formula (1E) include compounds represented by formulae (1E-1) to (1E-6) below.

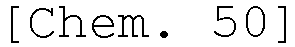

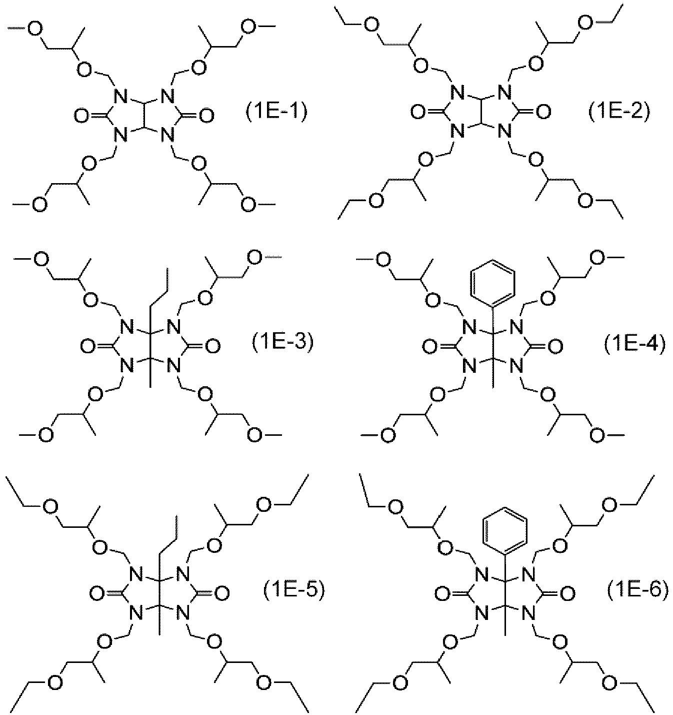

The glycoluril derivative represented by formula (1E) is obtained, for example, by a reaction of a glycoluril derivative represented by formula (2E) below with at least one compound represented by formula (3d) below.

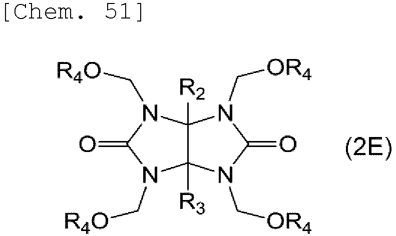

In formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.

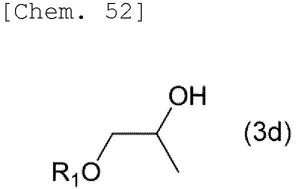

In formula (3d), R₁ represents a methyl group or an ethyl group.

Examples of the glycoluril derivative represented by formula (2E) include compounds represented by formula (2E-1) to formula (2E-4) below. Further, examples of the compound represented by formula (3d) include compounds represented by formula (3d-1) and formula (3d-2) below.

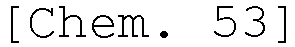

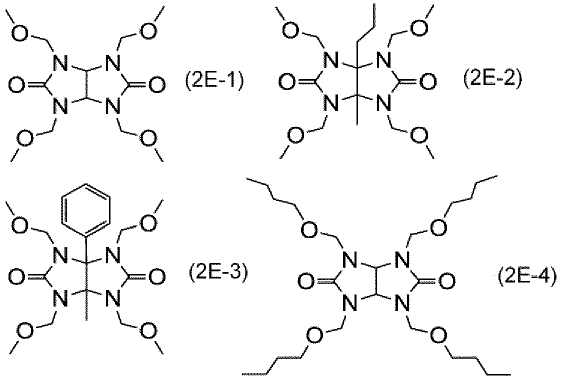

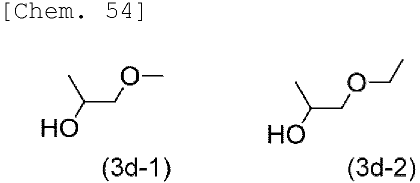

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by formula (G-1) or (G-2) below.

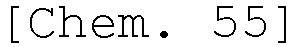

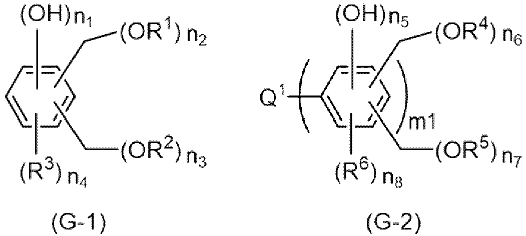

In formulae (G-1) and (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and an integer that meets 3 ≤ (n₁ + n₂ + n₃ + n₄) ≤ 6.

n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, n₈ represents an integer that meets 0 ≤ n₈ ≤ 3, and an integer that meets 2 ≤ (n₅ + n₆ + n₇ + n₈) ≤ 5.

m1 represents an integer of 2 to 10.

Examples of the compound having a phenolic hydroxy group include a compound represented by formula (G-3) or (G-4) below.

The compound represented by formula (G-1) or formula (G-2) may be obtained by a reaction of a compound represented by formula (G-3) or formula (G-4) below with a hydroxyl group-containing ether compound or an alcohol having 2 to 10 carbon atoms.

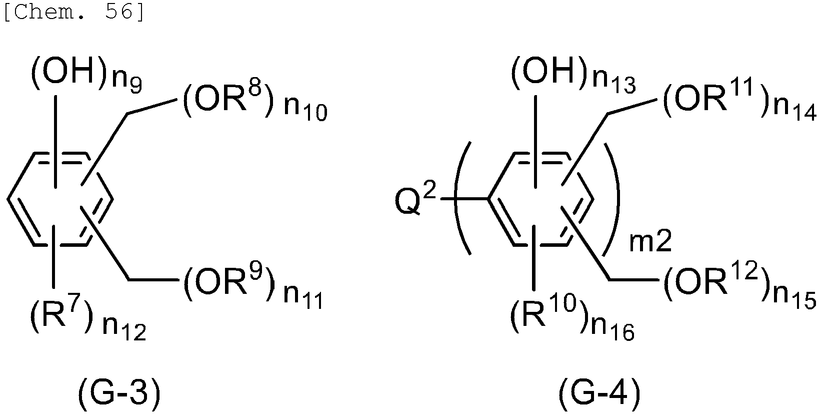

In formula (G-3) and formula (G-4), Q² represents a single bond or an m2-valent organic group,
R⁸, R⁹, R¹¹, and R¹² each represent a hydrogen atom or a methyl group,
R⁷ and R¹⁰ each represent an alkyl group having 1 to 10 carbon atoms or an aryl group having 6 to 40 carbon atoms,
n₉ represents an integer that satisfies 1 ≤ n₉ ≤ 3, n₁₀ represents an integer that satisfies 2 ≤ n₁₀ ≤ 5, n₁₁ represents an integer that satisfies 0 ≤ n₁₁ ≤ 3, n₁₂ represents an integer that satisfies 0 ≤ n₁₂ ≤ 3, and an integer that satisfies 3 ≤ (n₉ + n₁₀ + n₁₁ + n₁₂) ≤ 6,
n₁₃ represents an integer that satisfies 1 ≤ n₁₃ ≤ 3, n₁₄ represents an integer that satisfies 1 ≤ n₁₄ ≤ 4, n₁₅ represents an integer that satisfies 0 ≤ n₁₅ ≤ 3, and n₁₆ represents an integer that satisfies 0 ≤ n₁₆ ≤ 3, and an integer that satisfies 2 ≤ (n₁₃ + n₁₄ + n₁₅ + n₁₆) ≤ 5, and m2 represents an integer of 2 to 10.

Examples of the m2-valent organic group of Q² include an m2-valent organic group having 1 to 4 carbon atoms.

Examples of the compound represented by formula (G-1) or formula (G-2) include the following compounds.

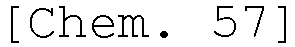

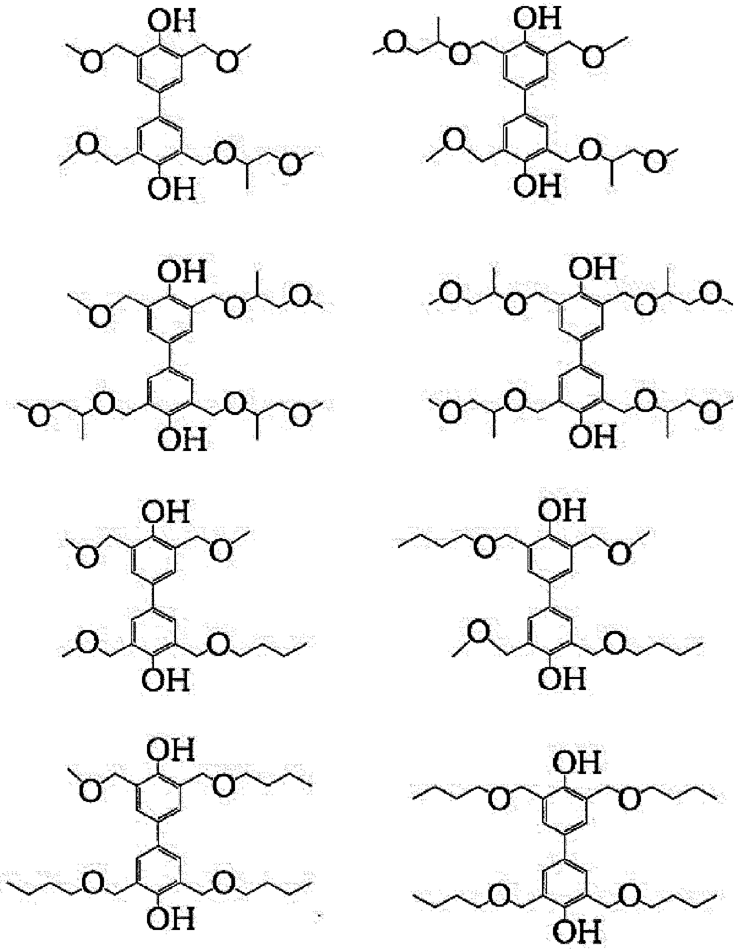

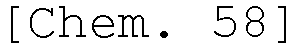

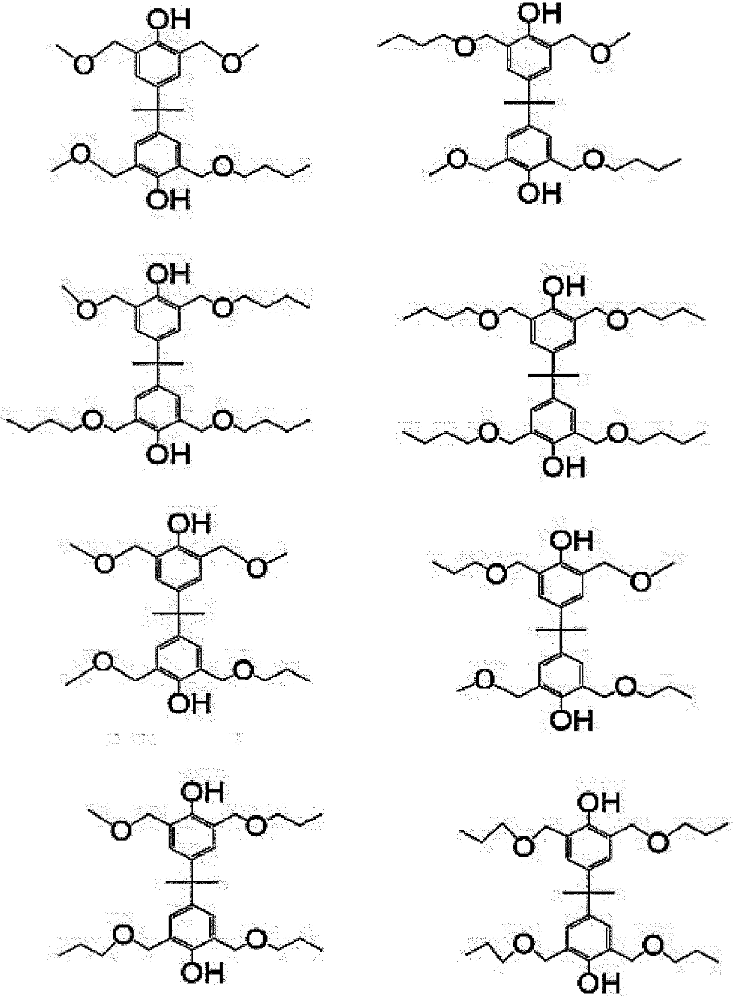

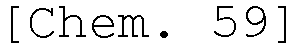

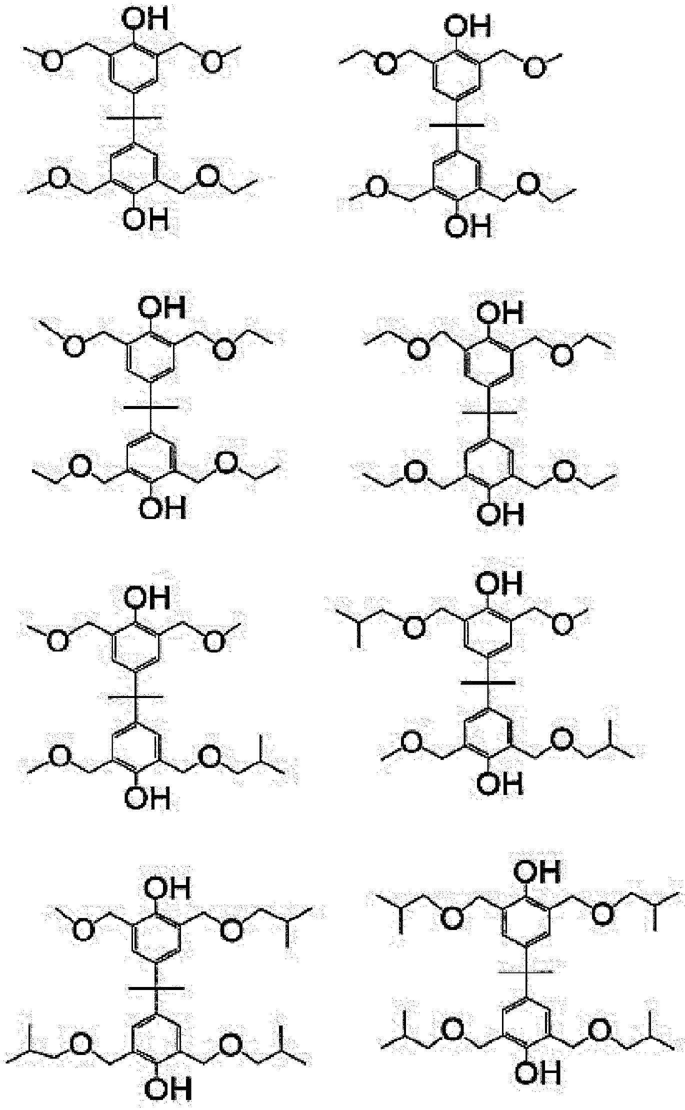

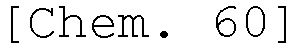

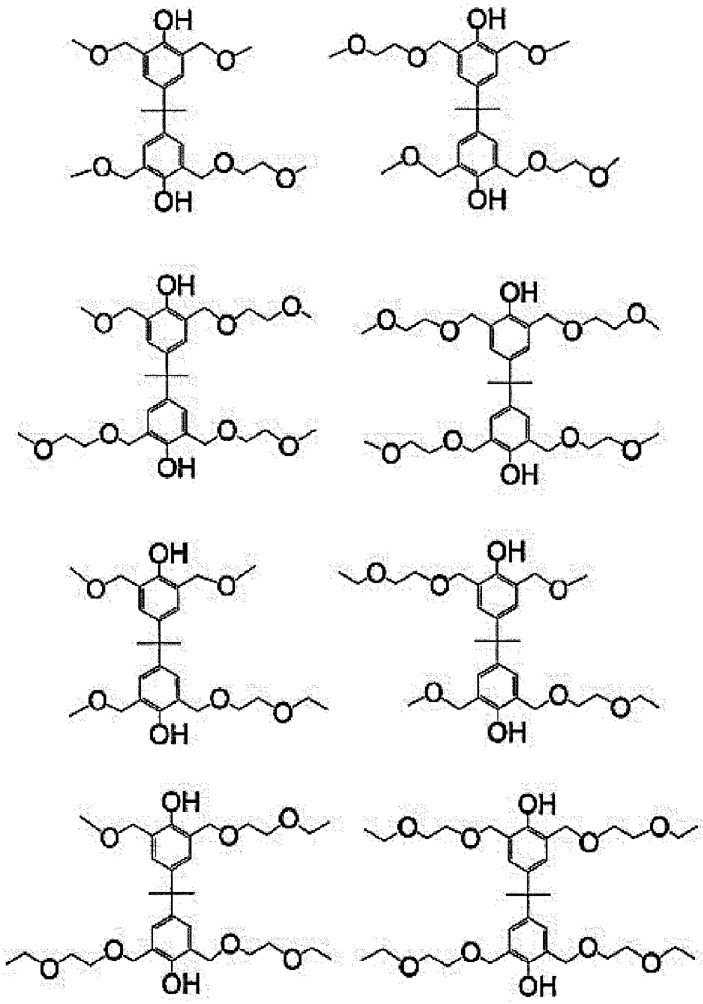

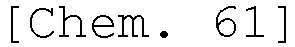

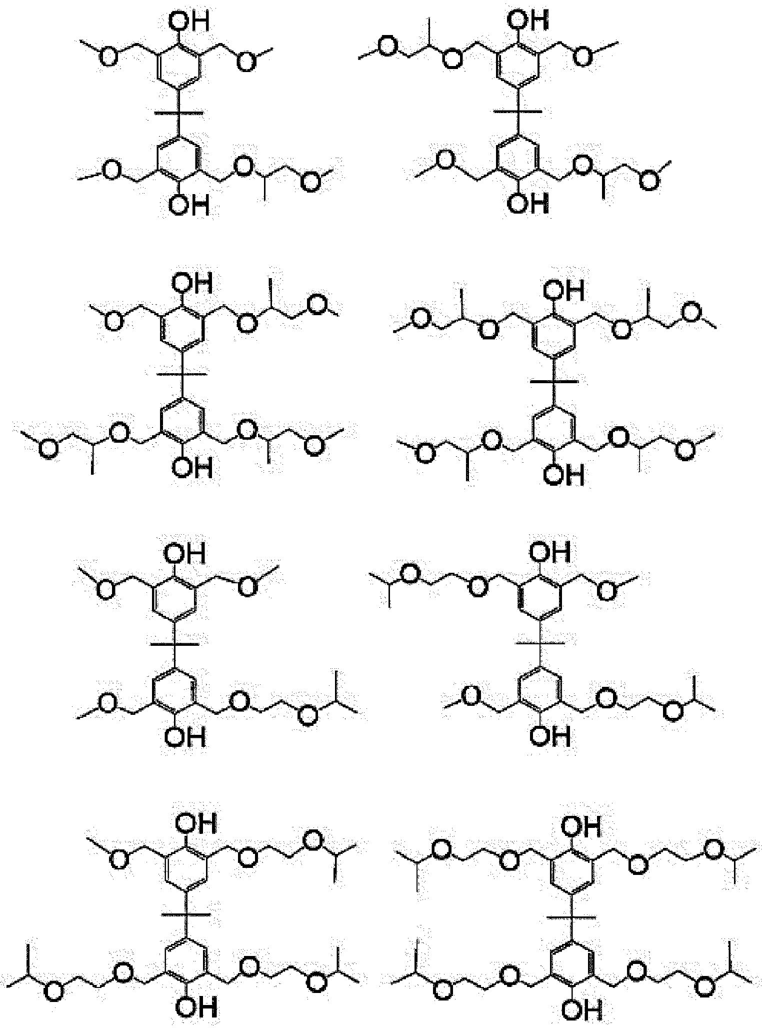

Examples of the compound represented by formula (G-3) or formula (G-4) include the following compounds.

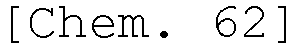

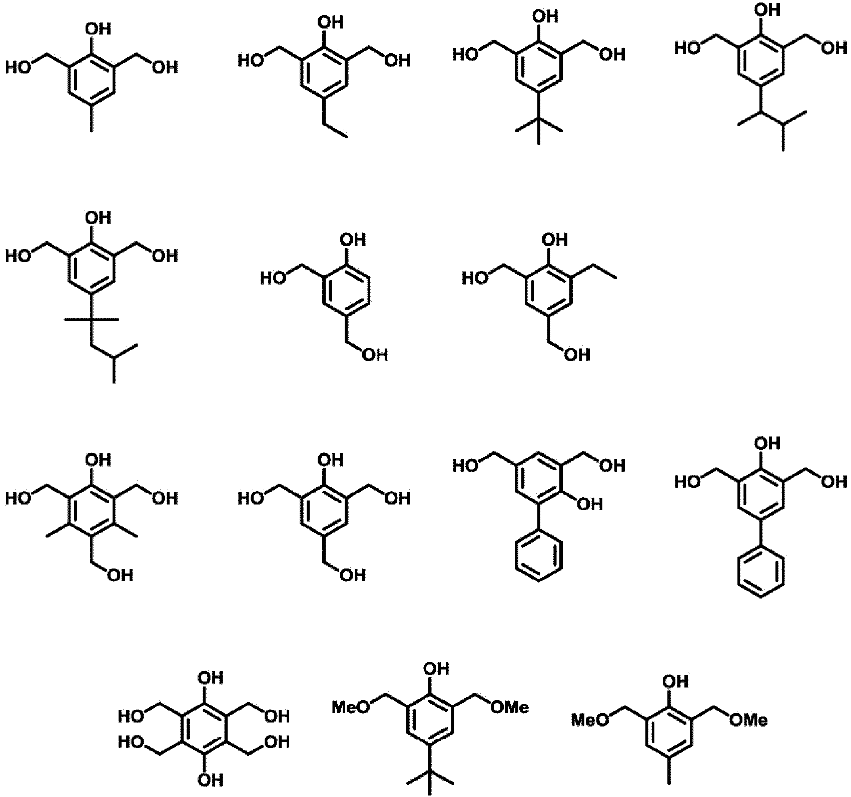

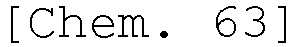

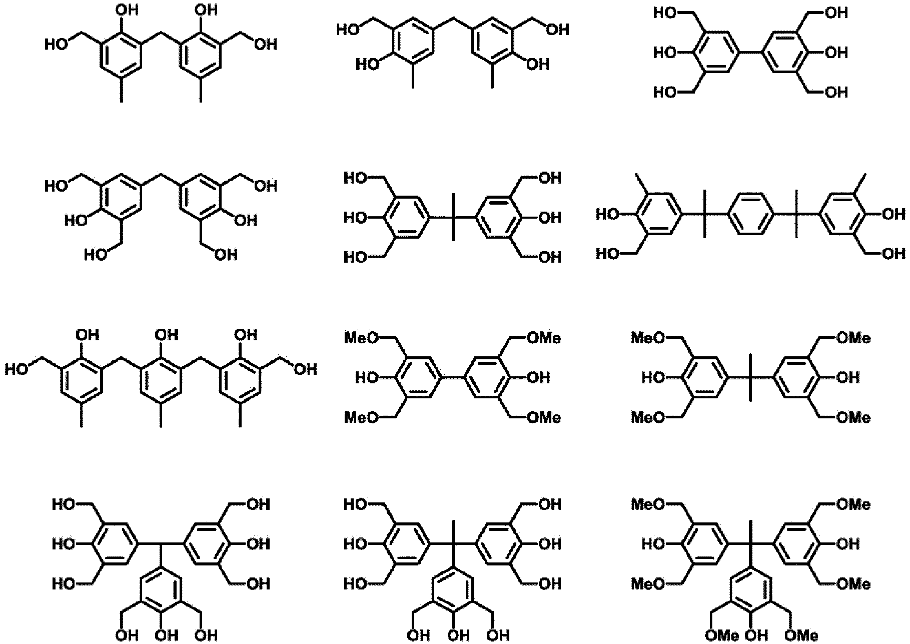

The compounds can be obtained as products of Asahi Yukizai Corporation and Honshu Chemical Industry Co., Ltd. Examples of the product include TMOM-BP (trade name) manufactured by Asahi Yukizai Corporation.

Among the compounds, the glycoluril compound is preferable. Specifically, tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof are preferable, and tetramethoxymethylglycoluril is preferable.

The molecular weight of the crosslinking agent is not particularly limited, but is preferably 500 or less.

The content of the crosslinking agent in the resist underlayer film-forming composition is not particularly limited, and is, for example, 1 mass% to 50 mass%, preferably 5 mass% to 40 mass%, relative to the polymer (A).

### <Curing catalyst>

As the curing catalyst contained as an optional component in the resist underlayer film-forming composition, both a thermal acid generator and a photoacid generator can be used, but it is preferable to use a thermal acid generator.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include an onium salt compound, a sulfonimide compound, and a disulfonyldiazomethane compound.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate, and the like.

Examples of the sulfonimide compound include N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, methylsulfonyl-p-toluenesulfonyl diazomethane, and the like.

Only one type of curing catalyst can be used, or two or more types thereof can be used in combination.

In a case where the curing catalyst is used, the content ratio of the curing catalyst is, for example, 0.1 mass% to 50 mass%, and preferably 1 mass% to 30 mass%, with respect to the crosslinking agent.

### <Other components>

To the resist underlayer film-forming composition, a surfactant can be further added in order to further improve the coatability against surface unevenness without generating a pinhole, a striation, and the like.

Examples of the surfactant include linear or branched alkylbenzenesulfonic acids (such as dodecylbenzenesulfonic acid); polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octylphenol ether and polyoxyethylene nonylphenol ether; polyoxyethylene/polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; nonionic surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by TOHKEM PRODUCTS Corporation, trade names); MEGAFACE F171, F173, and R-30 (manufactured by DIC Corporation, trade names); Fluorad FC430 and FC431 (manufactured by Sumitomo 3M Limited, trade names); AsahiGuard AG710 and Surflon S-382, SC101, SC102, SC103, SC104, SC105, and SC106 (manufactured by AGC Corporation, trade names); and organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition.

These surfactants may be added alone, or two or more types thereof can also be added in combination.

The resist underlayer film-forming composition may contain a polymerization inhibitor (radical trapping agent) as necessary. Examples of the polymerization inhibitor include 2,6-diisobutylphenol, 3,5-di-tert-butylphenol, 3,5-di-tert-butylcresol, hydroquinone, hydroquinone monomethyl ether, pyrogallol, tert-butylcatechol, and 4-methoxy-1-naphthol.

The content of the polymerization inhibitor in the resist underlayer film-forming composition is not particularly limited, but is preferably 1 mass% or less with respect to the solid content.

The amount of the solid content in the resist underlayer film-forming composition of the present invention, that is, the components excluding the solvent is, for example, 0.01 mass% to 10 mass%.

The resist underlayer film-forming composition is preferably used for EUV lithography.

The resist underlayer film-forming composition is preferably used for forming an underlayer film of a metal-containing resist.

### (Resist underlayer film)

The resist underlayer film of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using the semiconductor substrate having a surface on which an inorganic film is formed, the inorganic film is formed by, for example, an atomic layer deposition (ALD) method, a chemical vapor deposition (CVD) method, a reactive sputtering method, an ion plating method, a vacuum deposition method, or a spin coating method (spin-on-glass, SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Thereafter, baking is performed using a heating unit such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring the film thickness of the resist underlayer film in the present description is as follows.
· Measurement device name: Ellipsometric film thickness measurement device RE-3100 (SCREEN Holdings Co., Ltd.)
· Single wavelength ellipsometer (SWE) mode
· Arithmetic average of measurements at 8 points (for example, measurement is made at 8 points at intervals of 1 cm in X direction of wafer)

### (Laminate)

A laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Semiconductor element producing method and pattern forming method)

The semiconductor element producing method of the present invention includes at least the following steps.
· a step of forming a resist underlayer film on a semiconductor substrate using the resist underlayer film-forming composition of the present invention
· a step of forming a resist film on the resist underlayer film

The pattern forming method of the present invention includes at least the following steps.
· a step of forming a resist underlayer film on a semiconductor substrate using the resist underlayer film-forming composition of the present invention;
· a step of forming a resist film on the resist underlayer film;
· a step of irradiating the resist film with light or an electron beam, and then developing the resist film to obtain a resist pattern; and
· a step of etching the resist underlayer film using the resist pattern as a mask.

The resist layer is usually formed on the resist underlayer film.

The film thickness of the resist layer is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (for example, application and baking of a resist composition) is not particularly limited as long as it responds to light or an electron beam (EB) used for irradiation. Both a negative photoresist and a positive photoresist can be used.

In the present description, a resist that responds to an EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

In addition, so-called resist compositions such as resist compositions described in WO2019/188595, WO2019/187881, WO2019/187803, WO2019/167737, WO2019/167725, WO2019/187445, WO2019/167419, WO2019/123842, WO2019/054282, WO2019/058945, WO2019/058890, WO2019/039290, WO2019/044259, WO2019/044231, WO2019/026549, WO2018/193954, WO2019/172054, WO2019/021975, WO2018/230334, WO2018/194123, JP 2018-180525 A, WO2018/190088, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO2018/031896, JP 2019-113855 A, WO2017/156388, WO2017/066319, JP 2018-41099 A, WO2016/065120, WO2015/026482, JP 2016-29498 A, and JP 2011-253185 A, radiation-sensitive resin compositions, high-resolution patterning compositions based on organometallic solutions, and metal-containing resist compositions can be used, but are not limited to these.

Examples of the resist composition include the following compositions.

An actinic ray-sensitive or radiation-sensitive resin composition containing a resin A having a repeating unit having an acid-decomposable group in which a polar group is protected by a protecting group to be removed by an action of an acid, and a compound represented by general formula (121) below.

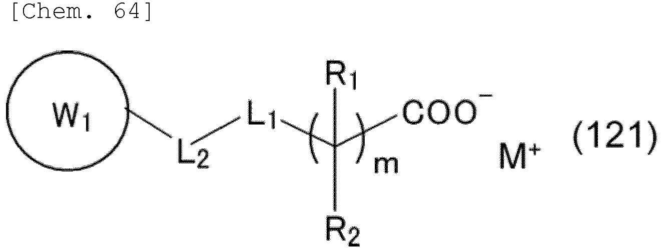

In general formula (121), m represents an integer of 1 to 6.
R₁ and R₂ each independently represent a fluorine atom or a perfluoroalkyl group.
L₁ represents -O-, -S-, -COO-, -SO₂-, or -SO₃-,
L₂ represents an alkylene group which may have a substituent, or a single bond,
W₁ represents a cyclic organic group which may have a substituent, and
M⁺ represents a cation.

A metal-containing film-forming composition for extreme ultraviolet or electron beam lithography, containing a compound having a metal-oxygen covalent bond and a solvent, in which metal elements included in the compound belong to periods 3 to 7 of groups 3 to 15 in the periodic table.

A radiation-sensitive resin composition that contains a polymer having a first structural unit represented by formula (31) below and a second structural unit represented by formula (32) below and containing an acid-dissociable group, and that contains an acid generator.

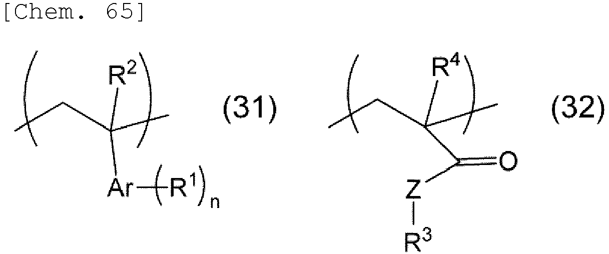

In formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹'s are identical or different, and R² is a hydrogen atom, a fluorine atom, a methyl group, or a trifluoromethyl group. In Formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition that contains a resin (A1) including a structural unit having a cyclic carbonate structure, a structural unit represented by the following formula, and a structural unit having an acid-unstable group, and that contains an acid generator.

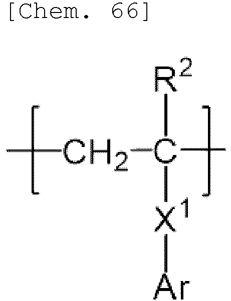

In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.

Examples of the resist film include the following resist film.

A resist film including a base resin including a repeating unit represented by formula (a1) below and/or a repeating unit represented by formula (a2) below, and a repeating unit that generates an acid bonded to a polymer main chain by exposure.

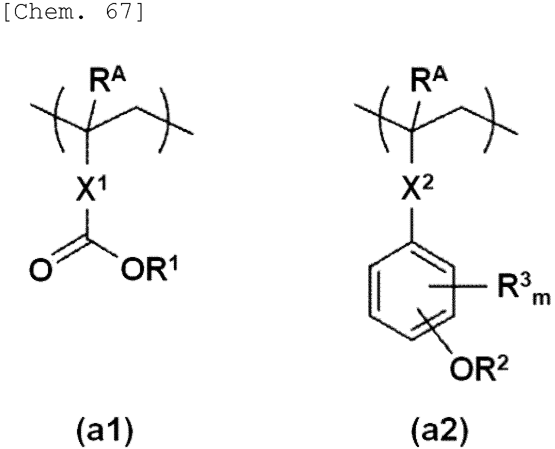

In formula (a1) and formula (a2), R^{A'} s are each independently a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.

Examples of the resist material include the following.

A resist material containing a polymer having a repeating unit represented by formula (b1) or formula (b2) below.

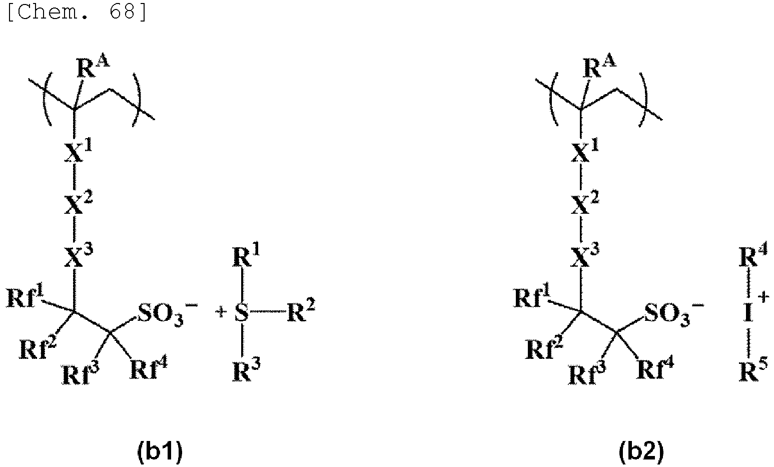

In formula (b1) and formula (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group are optionally substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all hydrogen atoms of these groups may be substituted with a hydroxy group, a carboxyl group, a halogen atom, an oxo group, a cyano group, an amide group, a nitro group, a sultone group, a sulfone group, or a sulfonium salt-containing group, and some of methylene groups included in these groups are optionally substituted with an ether group, an ester group, a carbonyl group, a carbonate group, or a sulfonic acid ester group, and R¹ and R² may be bonded to form a ring together with a sulfur atom to which R¹ and R² are bonded.

A resist material containing a base resin including a polymer having a repeating unit represented by formula (a) below.

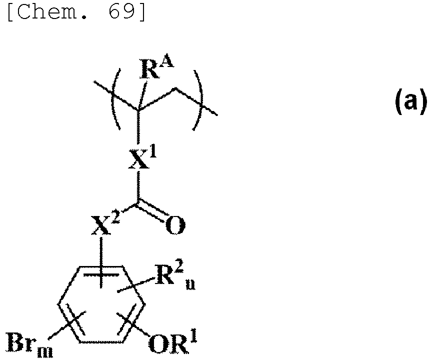

In formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer of 1 to 4, and u is an integer of 0 to 3, provided that m + u is an integer of 1 to 4.

A resist composition which generates an acid by exposure and of which solubility in a developer is changed by an action of the acid, the resist composition containing:
a base material component (A) of which solubility in a developer is changed by an action of an acid and a fluorine additive component (F) which exhibits decomposability in an alkaline developer, in which
the fluorine additive component (F) contains a fluororesin component (F1) having a constituent unit (f1) containing a base dissociable group and a constituent unit (f2) containing a group represented by general formula (f2-r-1) below.

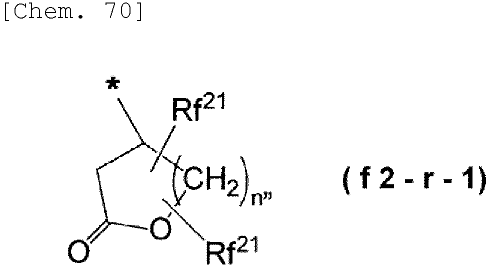

In formula (f2-r-1), Rf²¹'s each independently are a hydrogen atom, an alkyl group, an alkoxy group, a hydroxy group, a hydroxyalkyl group, or a cyano group, n" is an integer of 0 to 2, and * is a bond.

The constituent unit (f1) includes a constituent unit represented by the following general formula (f1-1) or a constituent unit represented by the following general formula (f1-2).

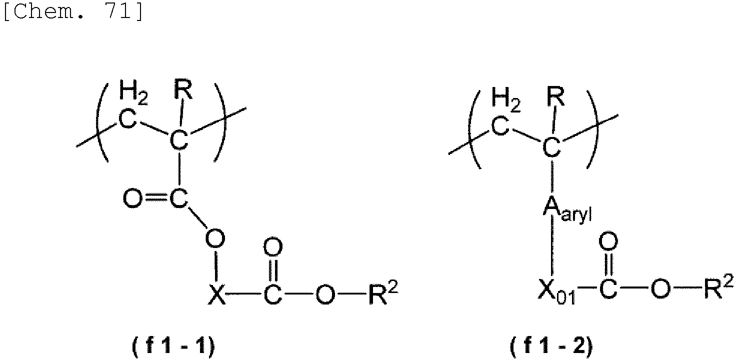

In formulae (f1-1) and (f1-2), R's are each independently a hydrogen atom, an alkyl group having 1 to 5 carbon atoms, or a haloalkyl group having 1 to 5 carbon atoms, X is a divalent linking group not having an acid-dissociable moiety, A_{aryl} is a divalent aromatic ring group which may have a substituent, X₀₁ is a single bond or a divalent linking group, and R²'s each independently are an organic group having a fluorine atom.

The resist composition may be a metal-containing resist.

The metal-containing resist is also called a metal oxide resist (metal oxide resist (MOR)), and typical examples thereof include a tin oxide-based resist.

Examples of the metal oxide resist material include a coating composition containing a metal oxo-hydroxo network having an organic ligand through a metal carbon bond and/or a metal carboxylate bond described in JP 2019-113855 A.

In an example of the metal-containing resist, a peroxo ligand is used as a radiation-sensitive stabilizing ligand. Details of the peroxo based metal oxo-hydroxo compounds are described, for example, in paragraph [0011] of JP 2019-532489 A: Patent Literature. Examples of the Patent Literature include US 9,176,377 B2, US 2013/0224652 A1, US 9,310,684 B2, US 2016/0116839 A1, and US 15/291738 A.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, in which R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (where 0 < x < 3), in which the solution contains from about 0.0025 M to about 1.5 M of tin, R is an alkyl group or a cycloalkyl group having 3 to 31 carbon atoms, and the alkyl group or cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein to the same extent as all the contents are specified.

The method for forming the metal-containing resist film from the metal-containing resist is not particularly limited, and examples thereof include a method in which a coating-type resist material (metal-containing resist film-forming composition) as the metal-containing resist is applied and fired.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as all the contents are specified. In JP 2017-116923 A, the metal-containing resist film in the present invention is referred to as a metal oxide-containing film.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 260°C, more preferably 70°C to 180°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer or an organic solvent is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

An organic solvent can be used as the developer for the metal-containing resist, and development is performed with the developer (solvent) after irradiation with light or an electron beam. As a result, for example, when a metal-containing negative resist film is used, the metal-containing resist film in an unexposed portion is removed, and a pattern of the metal-containing resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Further, a surfactant or the like can also be added to these developers.

Subsequently, the resist underlayer film is etched using the formed resist pattern as a mask. The etching may be dry etching or wet etching, but is preferably dry etching.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Next, the contents of the present invention will be specifically described with reference to Examples, but the present invention is not limited thereto.

The weight average molecular weights (Mw) of the polymers shown in the following synthesis examples are measurement results by gel permeation chromatography (GPC) method. In the measurement, a GPC apparatus manufactured by TOSOH CORPORATION was used, and measurement conditions are as follows.
· Measuring apparatus: HLC-8020GPC [trade name] (manufactured by TOSOH CORPORATION)
· GPC column: TSKgel G2000HXL x 2, G3000HXL x 1, G4000HXL x 1 [trade name] (all manufactured by TOSOH CORPORATION)
· Column temperature: 40°C
· Solvent: tetrahydrofuran (THF)
· Flow rate: 1.0 mL/min
· Standard sample: polystyrene (manufactured by TOSOH CORPORATION)

### <Synthesis Example 1>

In 130.00 g of propylene glycol monomethyl ether acetate, 63.64 g of glycidyl methacrylate and 6.36 g of 2,2'-azobisisobutyronitrile were dissolved. A reaction vessel was purged with nitrogen, and then the solution was heated and stirred at 100°C for about 24 hours. This reaction solution was added dropwise to isopropyl alcohol, and a precipitate was recovered by suction filtration, and then dried at 40°C under reduced pressure to recover a polymer 1. The weight average molecular weight Mw measured by GPC in terms of polystyrene was 3,700. The polymer obtained in this Synthesis Example has a structural unit represented by formula (1') below.

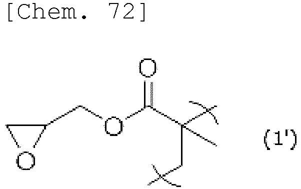

### <Synthesis Example 2>

To 20 g of propylene glycol monomethyl ether acetate and 20 g of propylene glycol monomethyl ether in a reaction vessel, 1.71 g of polyglycidyl methacrylate synthesized in Synthesis Example 1, 4.17 g of 4-((6-(methacryloyloxy)hexyl)oxy)cinnamic acid, 0.006 g of hydroquinone, and 0.12 g of tetrabutylphosphonium bromide were added and dissolved therein. The reaction vessel was purged with nitrogen, and then a reaction was allowed to proceed at 90°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the polymer in the obtained solution had a weight average molecular weight of 12000 in terms of standard polystyrene. The polymer obtained in this Synthesis Example has a structural unit represented by formula (1a) below.

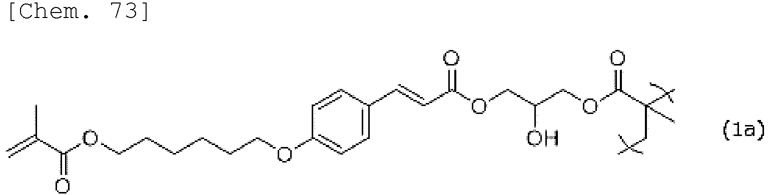

### <Synthesis Example 3>

To 20 g of propylene glycol monomethyl ether acetate and 20 g of propylene glycol monomethyl ether in a reaction vessel, 1.81 g of polyglycidyl methacrylate synthesized in Synthesis Example 1, 4.06 g of 4-{[6-(methacryloyloxy)hexyl]oxy}benzenecarboxylic acid, 0.007 g of hydroquinone, and 0.12 g of tetrabutylphosphonium bromide were added and dissolved therein. The reaction vessel was purged with nitrogen, and then a reaction was allowed to proceed at 90°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the polymer in the obtained solution had a weight average molecular weight of 10600 in terms of standard polystyrene. The polymer obtained in this Synthesis Example has a structural unit represented by formula (1b) below.

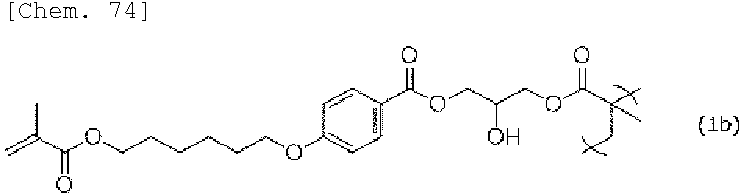

### <Synthesis Example 4>

To 20 g of propylene glycol monomethyl ether acetate and 20 g of propylene glycol monomethyl ether in a reaction vessel, 1.39 g of polyglycidyl methacrylate synthesized in Synthesis Example 1, 4.51 g of 4-[[4-[[6-[(1-oxo-2-propenyl)oxy]hexyl]oxy]benzoyl]oxy]benzenepropanoic acid, 0.005 g of hydroquinone, and 0.09 g of tetrabutylphosphonium bromide were added and dissolved therein. The reaction vessel was purged with nitrogen, and then a reaction was allowed to proceed at 90°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the polymer in the obtained solution had a weight average molecular weight of 11700 in terms of standard polystyrene. The polymer obtained in this Synthesis Example has a structural unit represented by formula (1c) below.

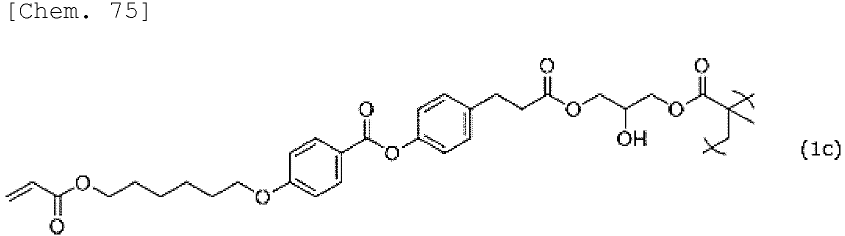

### <Synthesis Example 5>

To 20 g of propylene glycol monomethyl ether acetate and 20 g of propylene glycol monomethyl ether in a reaction vessel, 2.52 g of polyglycidyl methacrylate synthesized in Synthesis Example 1, 3.29 g of 4-hydroxyphenyl methacrylate, 0.009 g of hydroquinone, and 0.17 g of tetrabutylphosphonium bromide were added and dissolved therein. The reaction vessel was purged with nitrogen, and then a reaction was allowed to proceed at 90°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the polymer in the obtained solution had a weight average molecular weight of 18400 in terms of standard polystyrene. The polymer obtained in this Synthesis Example has a structural unit represented by formula (1d) below.

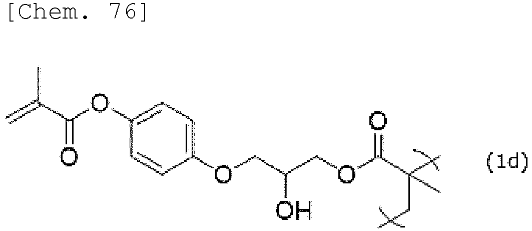

### <Synthesis Example 6>

To 23.67 g of propylene glycol monomethyl ether in a reaction vessel, 1.09 g of a cresol novolac type epoxy resin EOCN-104S (manufactured by Nippon Kayaku Co., Ltd.), 1.85 g of 4-((6-(methacryloyloxy)hexyl)oxy)cinnamic acid, 0.01 g of hydroquinone, and 0.05 g of tetrabutylphosphonium bromide were added and dissolved therein. The reaction vessel was purged with nitrogen, and then a reaction was allowed to proceed at 105°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the weight average molecular weight of the polymer in the obtained solution was 6000 in terms of standard polystyrene. The polymer obtained in this Synthesis Example has a structural unit represented by formula (1e) below.

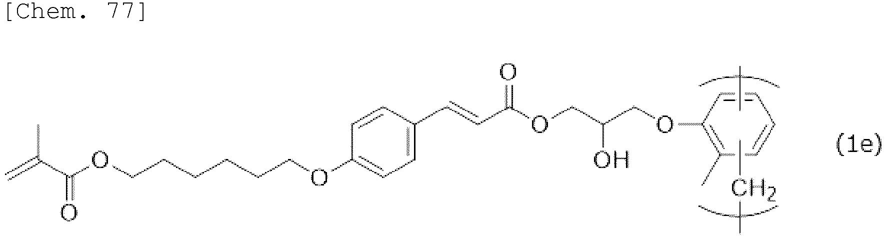

### <Synthesis Example 7>

To 37.02 g of propylene glycol monomethyl ether in a reaction vessel, 1.00 g of an alicyclic epoxy resin NER-HM (manufactured by Fine Chem), 5.50 g of 4-{[6-(methacryloyloxy)hexyl]oxy}benzenecarboxylic acid, 0.05 g of hydroquinone, and 0.19 g of tetrabutylphosphonium bromide were added and dissolved therein. The reaction vessel was purged with nitrogen, and then a reaction was allowed to proceed at 105°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the weight average molecular weight of the polymer in the obtained solution was 7180 in terms of standard polystyrene. The polymer obtained in this Synthesis Example has a structural unit represented by formula (1f) below.

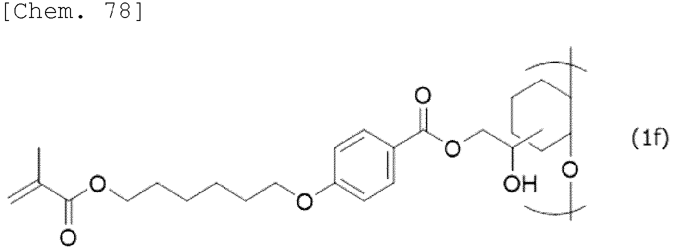

### <Synthesis Example 8>

To 46.65 g of propylene glycol monomethyl ether in a reaction vessel, 1.00 g of an alicyclic epoxy resin NER-HM (manufactured by Fine Chem), 7.91 g of 4-[[4-[[6-[(1-oxo-2-propenyl)oxy]hexyl]oxy]benzoyl]oxy]benzenepropanoic acid, 0.05 g of hydroquinone, and 0.19 g of tetrabutylphosphonium bromide were added and dissolved therein. The reaction vessel was purged with nitrogen, and then a reaction was allowed to proceed at 105°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the weight average molecular weight of the polymer in the obtained solution was 8240 in terms of standard polystyrene. The polymer obtained in this Synthesis Example has a structural unit represented by formula (1g) below.

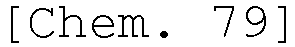

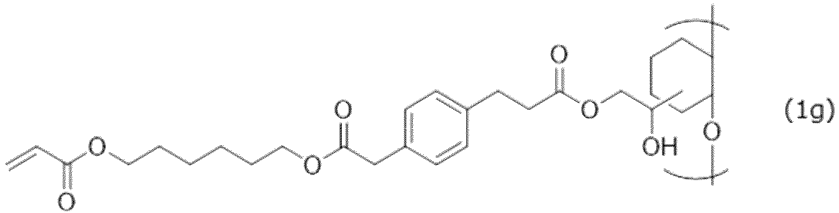

### <Synthesis Example 9>

To 32 g of propylene glycol monomethyl ether acetate and 32 g of propylene glycol monomethyl ether in a reaction vessel, 3.00 g of polyglycidyl methacrylate synthesized in Synthesis Example 1, 2.38 g of propionic acid, and 0.21 g of tetrabutylphosphonium bromide were added and dissolved therein. The reaction vessel was purged with nitrogen, and then a reaction was allowed to proceed at 80°C for 24 hours to prepare a polymer solution. The polymer solution does not become cloudy even when cooled to room temperature, and has good solubility in a mixed solvent of propylene glycol monomethyl ether/propylene glycol monomethyl ether acetate. When analysis was performed by GPC, the polymer in the obtained solution had a weight average molecular weight of 10426 in terms of standard polystyrene. The polymer obtained in this Synthesis Example has a structural unit represented by formula (2a) below.

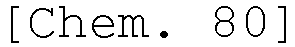

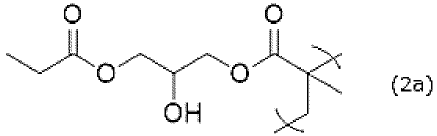

### (Preparation of resist underlayer film-forming composition 1)

To 0.66 g of the polymer solution (solid content: 13.1 mass%) obtained in Synthesis Example 2, 0.43 g of a 5 mass% propylene glycol monomethyl ether solution of tetramethoxymethyl glycoluril, 0.22 g of a 1 mass% propylene glycol monomethyl ether solution of pyridinium phenolsulfonic acid, 33 g of propylene glycol monomethyl ether, and 15 g of propylene glycol monomethyl ether acetate were added and dissolved therein. Thereafter, the mixture was filtered using a polyethylene microfilter having a pore size of 0.05 µm to form a resist underlayer film-forming composition 1 for lithography.

### (Preparation of resist underlayer film-forming composition 2)

To 0.66 g of the polymer solution (solid content: 13.0 mass%) obtained in Synthesis Example 3, 0.43 g of a 5 mass% propylene glycol monomethyl ether solution of tetramethoxymethyl glycoluril, 0.22 g of a 1 mass% propylene glycol monomethyl ether solution of pyridinium phenolsulfonic acid, 33 g of propylene glycol monomethyl ether, and 15 g of propylene glycol monomethyl ether acetate were added and dissolved therein. Thereafter, the mixture was filtered using a polyethylene microfilter having a pore size of 0.05 µm to form a resist underlayer film-forming composition 2 for lithography.

### (Preparation of resist underlayer film-forming composition 3)

To 0.66 g of the polymer solution (solid content: 13.0 mass%) obtained in Synthesis Example 4, 0.43 g of a 5 mass% propylene glycol monomethyl ether solution of tetramethoxymethyl glycoluril, 0.22 g of a 1 mass% propylene glycol monomethyl ether solution of pyridinium phenolsulfonic acid, 33 g of propylene glycol monomethyl ether, and 15 g of propylene glycol monomethyl ether acetate were added and dissolved therein. Thereafter, the mixture was filtered using a polyethylene microfilter having a pore size of 0.05 µm to form a resist underlayer film-forming composition 3 for lithography.

### (Preparation of resist underlayer film-forming composition 4)

To 0.74 g of the polymer solution (solid content: 10.05 mass%) obtained in Synthesis Example 5, 0.37 g of a 5 mass% propylene glycol monomethyl ether solution of tetramethoxymethyl glycoluril, 0.19 g of a 1 mass% propylene glycol monomethyl ether solution of pyridinium phenolsulfonic acid, 34 g of propylene glycol monomethyl ether, and 14 g of propylene glycol monomethyl ether acetate were added and dissolved therein. Thereafter, the mixture was filtered using a polyethylene microfilter having a pore size of 0.05 µm to form a resist underlayer film-forming composition 4.

### (Preparation of resist underlayer film-forming composition 5)

To 0.74 g of the polymer solution (solid content: 10.38 mass%) obtained in Synthesis Example 6, 0.37 g of a 5 mass% propylene glycol monomethyl ether solution of tetramethoxymethyl glycoluril, 0.19 g of a 1 mass% propylene glycol monomethyl ether solution of pyridinium phenolsulfonic acid, 34 g of propylene glycol monomethyl ether, and 14 g of propylene glycol monomethyl ether acetate were added and dissolved therein. Thereafter, the mixture was filtered using a polyethylene microfilter having a pore size of 0.05 µm to form a resist underlayer film-forming composition 5 for lithography.

### (Preparation of resist underlayer film-forming composition 6)

To 0.43 g of the polymer solution (solid content: 17.0 mass%) obtained in Synthesis Example 7, 0.37 g of a 5 mass% propylene glycol monomethyl ether solution of tetramethoxymethyl glycoluril (manufactured by Nihon Cytec Industries Inc.), 0.18 g of a 1 mass% propylene glycol monomethyl ether solution of pyridinium phenolsulfonic acid, 34 g of propylene glycol monomethyl ether, and 14 g of propylene glycol monomethyl ether acetate were added and dissolved therein. Thereafter, the mixture was filtered using a polyethylene microfilter having a pore size of 0.05 µm to form a resist underlayer film-forming composition 6 for lithography.

### (Preparation of resist underlayer film-forming composition 7)

To 0.46 g of the polymer solution (solid content: 16.3 mass%) obtained in Synthesis Example 8, 0.37 g of a 5 mass% propylene glycol monomethyl ether solution of tetramethoxymethyl glycoluril (manufactured by Nihon Cytec Industries Inc.), 0.19 g of a 1 mass% propylene glycol monomethyl ether solution of pyridinium phenolsulfonic acid, 34 g of propylene glycol monomethyl ether, and 15 g of propylene glycol monomethyl ether acetate were added and dissolved therein. Thereafter, the mixture was filtered using a polyethylene microfilter having a pore size of 0.05 µm to form a resist underlayer film-forming composition 7 for lithography.

### (Preparation of resist underlayer film-forming composition 8)

To 0.41 g of the polymer solution (solid content: 18.5 mass%) obtained in Synthesis Example 9, 0.38 g of a 5 mass% propylene glycol monomethyl ether solution of tetramethoxymethyl glycoluril (manufactured by Nihon Cytec Industries Inc.), 0.19 g of a 1 mass% propylene glycol monomethyl ether solution of pyridinium phenolsulfonic acid, 33 g of propylene glycol monomethyl ether, and 15 g of propylene glycol monomethyl ether acetate were added and dissolved therein. Thereafter, the mixture was filtered using a polyethylene microfilter having a pore size of 0.05 µm to form a resist underlayer film-forming composition 8 for lithography.

### <Preparation example of metal oxide resist>

### (Preparation of metal oxide resist composition)

In 9.84 g of 4-methyl-2-pentanol, 0.16 g of monobutyltin oxide (manufactured by Tokyo Chemical Industry Co., Ltd.) was dissolved. Thereafter, the mixture was filtered using a polyethylene microfilter having a pore size of 0.05 µm to form a metal oxide resist composition 1.

### <Example 1>

### (Evaluation of resist patterning)

### [Formation of metal oxide resist pattern by electron beam lithography apparatus]

The resist underlayer film-forming composition 1 was applied onto a silicon wafer using a spinner. The silicon wafer was baked on a hot plate at 215°C for 60 seconds to obtain a resist underlayer film having a film thickness of 5 nm. The metal oxide resist composition 1 prepared in the metal oxide resist preparation example was applied by spin coating onto the resist underlayer film, and heated at 100°C for 60 seconds to form a metal oxide resist film having a film thickness of 26 nm. Thereafter, exposure was performed under predetermined conditions using an electron beam lithography apparatus (ELS-G130) in order to form a target pattern. After the exposure, the film was baked (PEB) at 260°C for 60 seconds, and developed with a developer (a 5 mass% propylene glycol monomethyl ether acetate solution of acetic acid) to form a line-and-space pattern with a CD size of 22 nm and a pitch of 44 nm. A scanning electron microscope (CG4100 manufactured by Hitachi High-Technologies Corporation) was used to measure the length of the resist pattern. An observation photograph of the resist pattern formed in Example 1 is shown in Fig. 1.

### <Examples 2 to 7>

A line-and-space pattern having a CD size of 22 nm and a pitch of 44 nm was formed in the same manner as in Example 1 except that each of the resist underlayer film-forming compositions 2 to 7 was used instead of the resist underlayer film-forming composition 1.

### <Comparative Example 1>

A line-and-space pattern having a CD size of 22 nm and a pitch of 44 nm was formed in the same manner as in Example 1 except that the resist underlayer film-forming composition 8 was used instead of the resist underlayer film-forming composition 1.

The photoresist patterns obtained in Examples 1 to 7 and Comparative Example 1 were observed from the upper part of the pattern, and the irradiation energy (mC/cm²) at that time was confirmed using the charge amount for forming a 22 nm line/44 nm pitch (line-and-space (L/S = 1/1)) as the optimum irradiation energy. The results are shown in Table 1.

**[Table 1]**

| | Example 1 | Example 2 | Example 3 | Example 4 | Example 5 | Example 6 | Example 7 | Comparative Example 1 |
|---|---|---|---|---|---|---|---|---|
| Irradiation energy | 6.9 | 6.8 | 3.4 | 8.1 | 6.7 | 7.2 | 4.4 | 9.7 |
| (mC/cm²) | | | | | | | | |

From Table 1, in Examples 1 to 7, it is possible to reduce the irradiation energy required for pattern formation compared to Comparative Example 1, and the sensitivity of the resist is enhanced. Therefore, when this process is applied, the underlayer film-forming composition is useful for resist pattern formation.

## Claims

1. A resist underlayer film-forming composition, comprising a solvent and a polymer (A) having, in a side chain, an aromatic hydrocarbon ring and one type or two or more types of polymerizable multiple bonds selected from the group consisting of a carbon-carbon double bond, a carbon-carbon triple bond, a carbon-nitrogen double bond, and a carbon-nitrogen triple bond.

2. The resist underlayer film-forming composition according to claim 1, wherein the polymer (A) has a group represented by formula (A) below: 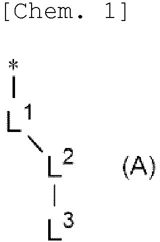 in formula (A), L¹ represents a single bond or a linking group, L² represents a divalent group having the aromatic hydrocarbon ring, L³ represents a monovalent group having the polymerizable multiple bond, and * represents a bond.

3. The resist underlayer film-forming composition according to claim 2, wherein in the group represented by formula (A), the L² is represented by formula (b) below: 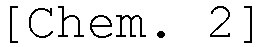 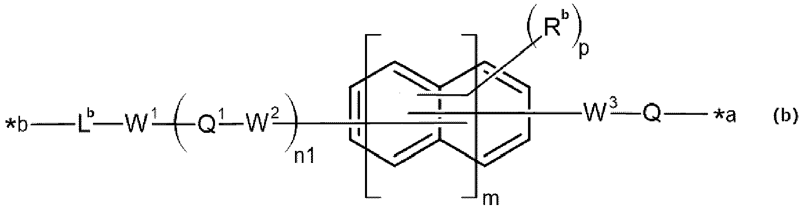 in formula (b),
W¹, W², and W³ are each independently a single bond, - O-, -C(=O)-O-, -O-C(=O)-, -O-C(=O)-CH₂-, -C(=O)-N(R')-, or -N(R')-C(=O)-, when the number of W²'s is 2 or more, the respective W²'s may be identical to or different from each other, and R' represents a hydrogen atom or an alkyl group having 1 to 6 carbon atoms,
Q is a single bond, an alkylene group having 1 to 10 carbon atoms, or an alkenylene group having 2 to 10 carbon atoms, and some or all hydrogen atoms in the alkylene group or the alkenylene group may be substituted with a halogen atom,
L^{b} represents a single bond, an alkylene group having 1 to 12 carbon atoms, or a divalent linking group in which one or more non-adjacent -CH₂- moieties constituting an alkylene group having 1 to 12 carbon atoms are substituted with -O-, -S-, -C(=O)-O-, or O-C(=O)-, and some or all hydrogen atoms in the alkylene group may be substituted with a halogen atom,
Q¹ is a single bond, a phenylene group, a naphthylene group, or a divalent alicyclic hydrocarbon group having 5 to 8 carbon atoms, and some or all hydrogen atoms in the phenylene group and the naphthylene group may be substituted with a cyano group, a halogen atom, an alkyl group having 1 to 5 carbon atoms, an alkylcarbonyl group having 2 to 6 carbon atoms, or an alkoxy group having 1 to 5 carbon atoms, when the number of Q¹'s is 2 or more, the respective Q¹'s may be identical to or different from each other,
R^{b} is an alkyl group having 1 to 6 carbon atoms, a haloalkyl group having 1 to 6 carbon atoms, an alkoxy group having 1 to 6 carbon atoms, a haloalkoxy group having 1 to 6 carbon atoms, a cyano group, or a nitro group,
p is 0, 1, 2, 3, or 4,
m is 0 or 1,
n1 is 0, 1, 2, or 3, and
*a and *b each represent a bond, and *a binds to L¹ and *b binds to L³.

4. The resist underlayer film-forming composition according to claim 3, wherein in the divalent group represented by formula (b) of L², a combination of W³ and Q is any of the following combinations: W³ is a single bond and Q is a single bond; W³ is a single bond and Q is an alkylene group having 1 to 10 carbon atoms; and W³ is a single bond and Q is an alkenylene group having 2 to 10 carbon atoms.

5. The resist underlayer film-forming composition according to claim 3, wherein in the divalent group represented by formula (b) of L², a combination of Q¹ and W² is any of the following combinations: Q¹ is a single bond and W² is a single bond; and when n1 is 1, Q¹ is a phenylene group and W² is -C(=O)-O-.

6. The resist underlayer film-forming composition according to claim 3, wherein in the divalent group represented by formula (b) of L², a combination of L^{b} and W¹ is any of the following combinations: L^{b} is a single bond and W¹ is a single bond; L^{b} is an alkylene group having 1 to 10 carbon atoms and W¹ is -O-C(=O)-CH₂-; and L^{b} is an alkylene group having 1 to 10 carbon atoms and W¹ is -O-.

7. The resist underlayer film-forming composition according to claim 2, wherein in the group represented by formula (A), the linking group of L¹ has a structural moiety represented by formula (t1) below or formula (t2) below: 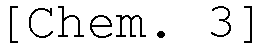 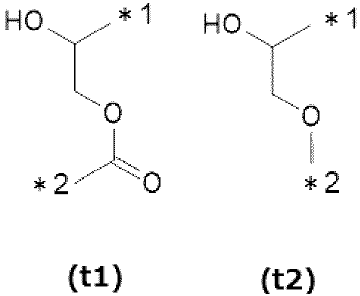 wherein *1 represents a bond on a side opposite to a side bonded to L² in formula (A), and *2 represents a bond bonded to L² in formula (A).

8. The resist underlayer film-forming composition according to claim 2, wherein in the group represented by formula (A), the monovalent group having a polymerizable multiple bond of L³ has a structural moiety represented by formula (u1) below or formula (u2) below: 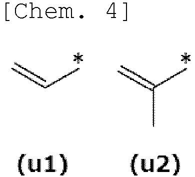 wherein * represents a bond bonded to L² in formula (A) .

9. The resist underlayer film-forming composition according to claim 1, wherein the polymer (A) has a structural unit represented by formula (1) below: 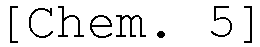 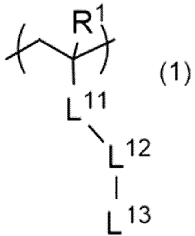 in formula (1), R¹ represents a hydrogen atom or an alkyl group having 1 to 10 carbon atoms, L¹¹ represents a single bond or a linking group, L¹² represents a divalent group having the aromatic hydrocarbon ring, and L¹³ represents a monovalent group having the polymerizable multiple bond.

10. The resist underlayer film-forming composition according to claim 9, wherein in the structural unit represented by formula (1), the linking group of L¹¹ is represented by formula (L1-1) below or formula (L1-2) below: 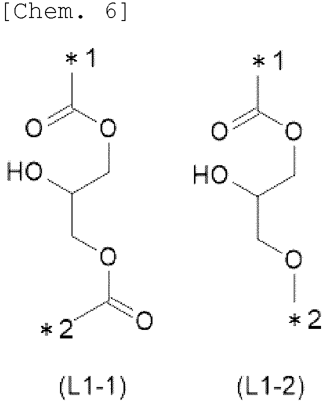 wherein *1 represents a bond bonded to a carbon atom bonded to R¹ in formula (1), and *2 represents a bond bonded to L¹² in formula (1).

11. The resist underlayer film-forming composition according to claim 1, wherein the polymer (A) has a structural unit represented by formula (2) below: 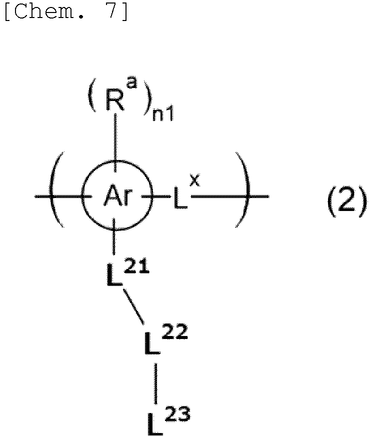 in formula (2), R^{a} represents a hydrogen atom or an alkyl group having 1 to 10 carbon atoms, Ar represents a benzene ring, a naphthalene ring, or an anthracene ring, L^{X} represents a single bond or a divalent group which may have a substituent, L²¹ represents a single bond or a linking group, L²² represents a divalent group having the aromatic hydrocarbon ring, L²³ represents a monovalent group having the polymerizable multiple bond, and n1 is an integer of 0 to 3.

12. The resist underlayer film-forming composition according to claim 11, wherein in the structural unit represented by formula (2), the linking group of L²¹ is represented by formula (L1-12) below: 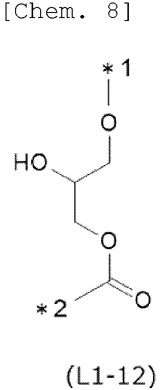 wherein *1 represents a bond bonded to Ar in formula (2), and *2 represents a bond bonded to L²² in formula (1).

13. The resist underlayer film-forming composition according to claim 1, wherein the polymer (A) has a structural unit represented by formula (3) below: 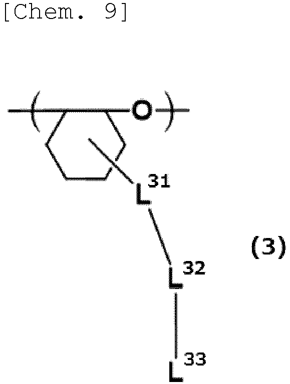 in formula (3), L³¹ represents a single bond or a linking group, L³² represents a divalent group having the aromatic hydrocarbon ring, and L³³ represents a monovalent group having the polymerizable multiple bond.

14. The resist underlayer film-forming composition according to claim 13, wherein in the structural unit represented by formula (3), the linking group of L³¹ is represented by formula (L1-13) below: 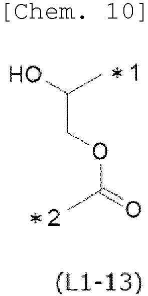 wherein *1 represents a bond bonded to an alicyclic hydrocarbon in formula (3), and *2 represents a bond bonded to L³² in formula (3).

15. The resist underlayer film-forming composition according to claim 1, further comprising a crosslinking agent.

16. A resist underlayer film, which is a cured product of the resist underlayer film-forming composition according to any one of claims 1 to 15.

17. A laminate, comprising:
a semiconductor substrate; and
the resist underlayer film according to claim 16.

18. A semiconductor element producing method, comprising steps of:
forming a resist underlayer film on a semiconductor substrate using the resist underlayer film-forming composition according to any one of claims 1 to 15; and
forming a resist film on the resist underlayer film.

19. A pattern forming method, comprising steps of:
forming a resist underlayer film on a semiconductor substrate using the resist underlayer film-forming composition according to any one of claims 1 to 15;
forming a resist film on the resist underlayer film;
irradiating the resist film with light or an electron beam, and then developing the resist film to obtain a resist pattern; and
etching the resist underlayer film using the resist pattern as a mask.
